# EUROPEAN PATENT APPLICATION

(11) **EP 4 431 570 A1**
(43) Date of publication of application: **18.09.2024**
(21) Application number: 22892558.2
(22) Date of filing: 24.10.2022
(51) Int. Cl.: C08L 101/00, C08J 5/22, C08K 3/08, C08K 5/09

(54) **RESIN COMPOSITION, RESIN FILM, AND DISPLAY DEVICE**

(30) Priority: 09.11.2021 JP 2021182433
(71) Applicant: Sumitomo Chemical Company Limited, Tokyo 103-6020 (JP)
(72) Inventor: TOKUDA, Masayoshi, Osaka-shi, Osaka 554-8558 (JP); KOMATSU, Yoshifumi, Osaka-shi, Osaka 554-8558 (JP); TSUCHIYA, Mitsuo, Osaka-shi, Osaka 554-8558 (JP); NISHIKAWA, Yukako, Osaka-shi, Osaka 554-8558 (JP)
(74) Representative: Vossius & Partner Patentanwälte Rechtsanwälte mbB
(86) International application number: PCT/JP2022/039468
(87) International publication number: WO 2023/085058

(57) **Abstract**

Provided are a resin composition comprising a semiconductor particle (A) and a resin (B), wherein a content of a polymerizable compound (C) and a content of a polymerization initiator (D) are each 0.01 % by mass or less based on a total amount of a solid content of the resin composition, and a ratio of the content of the semiconductor particle (A) to that of the resin (B) is 0.90 or less in terms of mass ratio; a resin film formed from the resin composition; and a display device comprising the resin film.

## Description

### Technical Field

The present invention relates to a resin composition, a resin film formed therefrom, and a display device including the resin film.

### Background Art

Patent Literature 1 discloses a curable resin composition including a semiconductor particle, a polymer having a specific structural unit, a polymerizable unsaturated compound, and a polymerization initiator, and a cured film formed by using the curable resin composition. The cured film is used as a wavelength conversion film or a light emission layer of a light emitting display device.

### Citation List

### Patent Literature

Patent Literature 1: Japanese Patent Laid-Open No. 2016-065178

### Summary of Invention

### Technical Problem

An object of the present invention is to provide a resin composition that contains a semiconductor particle and is capable of forming a resin film having good quantum yield. Another object of the present invention is to provide a resin film formed from the resin composition and a display device including the resin film.

### Solution to Problem

The present invention provides a resin composition, a resin film, and a display device shown below.
[1] A resin composition comprising a semiconductor particle (A) and a resin (B),
   wherein a content of a polymerizable compound (C) and a content of a polymerization initiator (D) are each 0.01 % by mass or less based on a total amount of a solid content of the resin composition, and
   a ratio of a content of the semiconductor particle (A) to that of the resin (B) is 0.90 or less in terms of mass ratio.
[2] The resin composition according to [1], wherein the resin composition further comprises an organic ligand (F) or no organic ligand (F), and
   a ratio of a total content of the semiconductor particle (A) and the organic ligand (F) to the content of the resin (B) is 1.00 or less in terms of mass ratio.
[3] The resin composition according to [1] or [2], wherein the content of the polymerizable compound (C) and the content of the polymerization initiator (D) are each 0 % by mass based on the total amount of the solid content of the resin composition.
[4] The resin composition according to any one of [1] to [3], wherein a ratio of the weight-average molecular weight of the resin (B) to an acid value of the resin (B) is 150 or less.
[5] The resin composition according to any one of [1] to [4], further comprising a light scattering agent (E).
[6] The resin composition according to any one of [1] to [5], having a viscosity of 100 mPa·s or more and 30000 mPa·s or less at 25°C.
[7] A resin film formed from the resin composition according to any one of [1] to [6].
[8] A display device comprising the resin film according to [7].

### Advantageous Effects of Invention

There can be provided a resin composition that contains a semiconductor particle and is capable of forming a resin film having good quantum yield, a resin film formed from the resin composition, and a display device including the resin film.

### Description of Embodiments

### <Resin composition>

The resin composition according to the present invention (hereinafter, also simply referred to as "resin composition") contains a semiconductor particle (A) and a resin (B).

### [1] Semiconductor particle (A)

The semiconductor particle (A) emits light having a wavelength different from that of primary light, and preferably converts a wavelength of blue light as primary light to a wavelength of light different therefrom. The semiconductor particle (A) preferably emits green light or red right, and it more preferably absorbs blue light and emits green light or red right.

The semiconductor particle (A) may be, for example, a red light emissive semiconductor particle that emits light having a peak wavelength of light emission within a wavelength range of 605 nm or more and 665 nm or less; a green light emissive semiconductor particle that emits light having a peak wavelength of light emission within a wavelength range of 500 nm or more and 560 nm or less; or a blue light emissive semiconductor particle that emits light having a peak wavelength of light emission within a wavelength range of 420 nm or more and 480 nm or less. The semiconductor particle (A) is preferably a red light emissive semiconductor particle and/or a green light emissive semiconductor particle. The peak wavelength of light emission of the semiconductor particle (A) can be determined in light emission spectrum measured using an ultraviolet and visible spectrophotometer, for example.

The full width at half maximum of the light emission spectrum of the semiconductor particle (A) is preferably 60 nm or less, more preferably 55 nm or less, even more preferably 50 nm or less, and particularly preferably 45 nm or less. Owing to this, light with higher color purity can be emitted. The lower limit of the full width at half maximum of the light emission spectrum of the semiconductor particle (A) is not particularly limited, and the full width at half maximum may be 5 nm or more, or 15 nm or more.

The semiconductor particle (A) is a semiconductor crystal particle and preferably a semiconductor crystal nanoparticle. Preferable examples of the semiconductor particle (A) include semiconductor quantum dots (hereinafter also referred to as "quantum dots") and a particle of a compound having a perovskite crystal structure (hereinafter also referred to as "perovskite compound"), and the semiconductor particle (A) is more preferably quantum dots.

The average particle size of the quantum dots is, for example, 0.5 nm or more and 20 nm or less, and preferably 1 nm or more and 15 nm or less (e.g., 2 nm or more and 15 nm or less). Since the energy state of the quantum dots depends on its size, the emission wavelength can be freely selected by changing the particle size. For example, in the case of quantum dots composed of only CdSe, the peak wavelengths of the light emission spectrum when the particle sizes are 2.3 nm, 3.0 nm, 3.8 nm, and 4.6 nm are 528 nm, 570 nm, 592 nm, and 637 nm, respectively. The average particle size of the semiconductor particle (A) can be determined using a scanning transmission electron microscope.

The quantum dots can be made, for example, of a semiconductor material containing one or more elements selected from the group consisting of Group 2 elements, Group 11 elements, Group 12 elements, Group 13 elements, Group 14 elements, Group 15 elements, and Group 16 elements of the periodic table.

Specific examples of the semiconductor material that can make the quantum dots include:
compounds of a Group 14 element and a Group 16 element, such as SnS₂, SnS, SnSe, SnTe, PbS, PbSe, and PbTe;
compounds of a Group 13 element and a Group 15 element, such as GaN, GaP, GaAs, GaSb, InN, InP, InAs, InSb, InGaN, and InGaP;
compounds of a Group 13 element and a Group 16 element, such as Ga₂O₃, Ga₂S₃, Ga₂Se₃, Ga₂Te₃, In₂O₃, In₂S₃, In₂Se₃, and In₂Te₃;
compounds of a Group 12 element and a Group 16 element, such as ZnO, ZnS, ZnSe, ZnTe, CdO, CdS, CdSe, CdTe, HgO, HgS, HgSe, HgTe, ZnSTe, ZnSeS, ZnSeTe, CdSTe, CdSeTe, HgSTe, HgSeS, and HgSeTe;
compounds of a Group 15 element and a Group 16 element, such as As₂O₃, As₂S₃, As₂Se₃, As₂Te₃, Sb₂O₃, Sb₂S₃, Sb₂Se₃, Sb₂Te₃, Bi₂O₃, Bi₂S₃, Bi₂Se₃, and Bi₂Te₃;
compounds of a Group 2 element and a Group 16 element, such as MgS, MgSe, MgTe, CaS, CaSe, CaTe, SrS, SrSe, SrTe, BaS, BaSe, and BaTe; and
a simple substance of a Group 14 element, a Group 15 element, a Group 16 element, such as Si and Ge.

The quantum dot optionally has a single layer structure made of a single semiconductor material, or optionally has a core-shell structure having a nucleus particle (core layer) made of a single semiconductor material and a coating layer (shell layer) made of one or more semiconductor materials different from that of the core layer, the coating layer covering the surface of the core layer. In the latter case, a semiconductor material that has a larger band-gap energy than the semiconductor material of the core layer is generally used as the semiconductor material of the shell layer. The quantum dot optionally has two or more shell layers. The shape of the quantum dot is not particularly limited, and may be spherical or almost spherical, rod-shaped, disc-shaped, etc.

The perovskite compound is a compound having a perovskite crystal structure and containing components A, B, and X.

In the perovskite crystal structure, A is the component located at each vertex of the hexahedron having B as the center, and is a monovalent cation.

In the perovskite crystal structure, X is the component located at each vertex of the octahedron having B as the center, and is at least one ion selected from the group consisting of halide ions and a thiocyanate ion.

In the perovskite crystal structure, B is the component located at the centers of the hexahedron having A at the vertices and the octahedron having X at the vertices, and is a metal ion.

From the viewpoint of favorably maintaining the crystal structure, the average particle size of the semiconductor particle made of the perovskite compound is preferably 3 nm or more, more preferably 4 nm or more, even more preferably 5 nm or more, and generally 50 nm or less.

The perovskite compound having component A, B, and X is not particularly limited, and may be a compound having any of a three-dimensional structure, a two-dimensional structure, and a pseudo two-dimensional structure.

In the case of the three-dimensional structure, the perovskite compound is represented by ABX_{(3+δ)}.

In the case of the two-dimensional structure, the perovskite compound is represented by A₂BX_{(4+δ)}.

δ is an appropriate variable number according to the charge balance of B, and is -0.7 or more and 0.7 or less.

Specific preferable examples of the perovskite compound having a three-dimensional structure of the perovskite crystal structure represented by ABX_{(3+δ)} include
CH₃NH₃PbBr₃, CH₃NH₃PbCl₃, CH₃NH₃PbI₃, CH₃NH₃PbBr_{(3-y)}I_{y} (0 < y < 3), CH₃NH₃PbBr_{(3-y)}Cl_{y} (0 < y < 3), (H₂N=CH-NH₂) PbBr₃, (H₂N=CH-NH₂) PbCl₃, (H₂N=CH-NH₂) Pbl₃,
CH₃NH₃Pb₍₁₋ₐ₎CaₐBr₃ (0 < a ≤ 0.7), CH₃NH₃Pb₍₁ -ₐ₎SrₐBr₃ (0 < a ≤ 0.7), CH₃NH₃Pb₍₁₋ₐ₎LaₐBr_{(3+δ)} (0 < a ≤ 0.7, 0 < δ ≤ 0.7), CH₃NH₃Pb₍₁₋ₐ₎ BaₐBr₃ (0 < a ≤ 0.7), CH₃NH₃Pb₍₁₋ₐ₎DyaBr_{(3+δ)} (0 < a ≤ 0.7, 0 < δ ≤ 0.7),
CH₃NH₃Pb₍₁₋ₐ₎NaₐBr_{(3+δ)} (0 < a ≤ 0.7, -0.7 ≤ δ < 0), CH₃NH₃Pb₍₁₋ₐ₎LiₐBr_{(3+δ)} (0 < a ≤ 0.7, -0.7 ≤ δ < 0),
CsPb₍₁₋ₐ₎NaₐBr_{(3+δ)} (0 < a ≤ 0.7, -0.7 ≤ δ < 0), CsPb₍₁₋ₐ₎LiₐBr_{(3+δ)} (0 < a ≤ 0.7, -0.7 ≤ δ < 0),
CH₃NH₃Pb₍₁₋ₐ₎NaₐBr_{(3+δ-y)}I_{y} (0 < a ≤ 0.7, -0.7 ≤ δ < 0, 0 < y < 3), CH₃NH₃Pb₍₁₋ₐ₎LiₐBr_{(3+δ-y)} I_{y} (0 < a ≤ 0.7, -0.7 ≤ δ < 0, 0 < y < 3), CH₃NH₃Pb(₁₋ₐ₎NaₐBr_{(3+δ-y)}Cl_{y} (0 < a ≤ 0.7, -0.7 ≤ δ < 0, 0 < y < 3), CH₃NH₃Pb₍₁₋ₐ₎LiₐBr_{(3+δ-y)}Cl_{y} (0 < a ≤ 0.7, -0.7 ≤ δ < 0, 0 < y < 3),
(H₂N=CH-NH₂)Pb₍₁₋ₐ₎NaₐBr_{(3+δ)} (0 < a ≤ 0.7, -0.7 ≤ δ < 0), (H₂N=CH-NH₂) Pb₍₁₋ₐ₎LiₐBr_{(3+δ)} (0 < a ≤ 0.7, -0.7 ≤ δ < 0), (H₂N=CH-NH₂)Pb₍₁₋ₐ₎NaₐBr_{(3+δ-y)}I_{y} (0 < a ≤ 0.7, -0.7 ≤ δ < 0, 0 < y < 3), (H₂N=CH-NH₂)Pb₍₁₋ₐ₎NaₐBr_{(3+δ-y})Cl_{y} (0 < a ≤ 0.7, - 0.7 ≤ δ < 0, 0 < y < 3),
CsPbBr₃, CsPbCl₃, CsPbI₃, CsPbBr_{(3-y)}I_{y} (0 < y < 3), CsPbBr_{(3-y)}Cl_{y} (0 < y < 3), CH₃NH₃PbBr_{(3-y)}Cl_{y} (0 < y < 3),
CH₃NH₃Pb₍₁₋ₐ₎ZnₐBr₃ (0 < a ≤ 0.7), CH₃NH₃Pb(₁₋ₐ₎AlₐBr_{(3+δ)} (0 < a ≤ 0.7, 0 ≤ δ ≤ 0.7), CH₃NH₃Pb₍₁₋ₐ₎CoₐBr₃ (0 < a ≤ 0.7), CH₃NH₃Pb₍₁₋ₐ₎MnₐBr₃ (0 < a ≤ 0.7), CH₃NH₃Pb₍₁₋ₐ₎MgₐBr₃ (0 < a ≤ 0.7),
CsPb₍₁₋ₐ₎ ZnₐBr₃ (0 < a ≤ 0.7), CsPb ₍₁₋ₐ₎AlₐBr _{(3+δ)} (0 < a ≤ 0.7, 0 < δ ≤ 0.7), CsPb₍₁₋ₐ₎CoₐBr₃ (0 < a ≤ 0.7), CsPb₍₁₋ₐ₎MnₐBr₃ (0 < a ≤ 0.7), CsPb₍₁₋ₐ₎MgₐBr₃ (0 < a ≤ 0.7),
CH₃NH₃Pb₍₁₋ₐ₎ZnₐBr_{(3-y)}I_{y} (0 < a ≤ 0.7, 0 < y < 3), CH₃NH₃Pb₍₁₋ₐ₎AlₐBr_{(3+δ-y})I_{y} (0 < a ≤ 0.7, 0 < δ ≤ 0.7, 0 < y < 3), CH₃NH₃Pb₍₁₋ₐ₎CoₐBr_{(3-y)}I_{y} (0 < a ≤ 0.7, 0 < y < 3), CH₃NH₃Pb₍₁₋ₐ₎MnₐBr_{(3-y)}I_{y} (0 < a ≤ 0.7, 0 < y < 3), CH₃NH₃Pb₍₁₋ₐ₎MgₐBr_{(3-y)}I_{y} (0 < a ≤ 0.7, 0 < y < 3), CH₃NH₃Pb₍₁₋ₐ)ZnₐBr_{(3-y)}Cl_{y} (0 < a ≤ 0.7, 0 < y < 3), CH₃NH₃Pb₍₁₋ₐ₎AlₐBr_{(3+δ-y)}Cl_{y} (0 < a ≤ 0.7, 0 < δ ≤ 0.7, 0 < y < 3), CH₃NH₃Pb₍₁₋ₐ₎CoₐBr_{(3+δ-y)}Cl_{y} (0 < a ≤ 0.7, 0 < y < 3), CH₃NH₃Pb₍₁₋ₐ₎MnₐBr_{(3-y)}Cl_{y} (0 < a ≤ 0.7, 0 < y < 3), CH₃NH₃Pb₍₁₋ₐ₎MgₐBr_{(3-y)}Cl_{y} (0 < a ≤ 0.7, 0 < y < 3),
(H₂N=CH-NH₂) ZnₐBr₃ (0 < a ≤ 0.7), (H₂N=CH-NH₂)MgₐBr₃ (0 < a ≤ 0.7), (H_{2N}=CH-NH₂) Pb₍₁₋ₐ₎ ZnₐBr_{(3-y)} I_{y} (0 < a ≤ 0.7, 0 < y < 3), and (H₂N=CH-NH₂) Pb₍₁₋ₐ₎ZnₐBr_{(3-y)}Cl_{y} (0 < a ≤ 0.7, 0 < y < 3).

Specific preferable examples of the perovskite compound having a two-dimensional structure of the perovskite crystal structure represented by A₂BX_{(4+δ)} include
(C₄H₉NH₃)₂PbBr₄, (C₄H₉NH₃)₂PbCl₄, (C₄H₉NH₃)₂PbI₄, (C₇H₁₅NH₃)₂PbBr₄, (C₇H₁₅NH₃)₂PbCl₄, (C₇H₁₅NH₃)₂PbI₄, (C₄H₉NH₃)₂Pb₍₁₋ₐ₎LiₐBr_{(4+δ)} (0 < a ≤ 0.7, -0.7 ≤ δ < 0), (C₄H₉NH₃)₂Pb₍₁₋ₐ₎NaₐBr_{(4+δ)} (0 < a ≤ 0.7, -0.7 ≤ 8 < 0), (C₄H₉NH₃)₂Pb₍₁₋ₐ₎RbaBr_{(4+δ)} (0 < a ≤ 0.7, -0.7 ≤ δ < 0),
(C₇H₁₅NH₃)₂Pb₍₁₋ₐ₎NaₐBr_{(4+δ)} (0 < a ≤ 0.7, -0.7 ≤ δ < 0), (C₇H₁₅NH₃)₂Pb₍₁₋ₐ₎LiₐBr_{(4+δ)} (0 < a ≤ 0.7, -0.7 ≤ δ < 0), (C₇H₁₅NH₃)₂Pb₍₁₋ₐ₎RbaBr_{(4+δ)} (0 < a ≤ 0.7, -0.7 ≤ δ < 0),
(C₄H₉NH₃)₂Pb₍₁₋ₐ₎NaₐBr_{(4+δ-y)}I_{y} (0 < a ≤ 0.7, -0.7 ≤ δ < 0, 0 < y < 4), (C₄H₉NH₃)₂Pb₍₁₋ₐ₎LiₐBr_{(4+δ-y)}I_{y} (0 < a ≤ 0.7, -0.7 ≤ δ < 0, 0 < y < 4), (C₄H₉NH₃)₂Pb₍₁₋ₐ₎RbₐBr_{(4+δ-y)}I_{y} (0 < a ≤ 0.7, -0.7 ≤ δ < 0, 0 < y < 4),
(C₄H₉NH3)₂Pb₍₁₋ₐ₎NaₐBr_{(4+δ-y)}Cl_{y} (0 < a ≤ 0.7, -0.7 ≤ δ < 0, 0 < y < 4), (C₄H₉NH₃)₂Pb₍₁₋ₐ₎LiₐBr_{(4+δ-y)}Cl_{y} (0 < a ≤ 0.7, - 0.7 ≤ δ < 0, 0 < y < 4), (C₄H₉NH₃)₂Pb₍₁₋ₐ₎RbₐBr_{(4+δ-y)}Cl_{y} (0 < a ≤ 0.7, -0.7 ≤ δ < 0, 0 < y < 4),
(C₄H₉NH₃)₂PbBr₄, (C₇H₁₅NH₃) ₂PbBr₄,
(C₄H₉NH₃)₂PbBr_{(4-y)}Cl_{y} (0 < y < 4), (C₄H₉NH₃)₂PbBr_{(4-y)}I_{y} (0 < y < 4),
(C₄H₉NH₃)₂Pb₍₁₋ₐ₎ZnₐBr₄ (0 < a ≤ 0.7), (C₄H₉NH₃)₂Pb₍₁₋ₐ₎MgₐBr₄ (0 < a ≤ 0.7), (C₄H₉NH₃)₂Pb₍₁₋ₐ₎CoₐBr₄ (0 < a ≤ 0.7), (C₄H₉NH₃)₂Pb₍₁₋ₐ₎MnₐBr₄ (0 < a ≤ 0.7),
(C₇H₁₅NH₃)₂Pb₍₁₋ₐ₎ZnₐBr₄ (0 < a ≤ 0.7), (C₇H₁₅NH₃)₂Pb₍₁₋ₐ₎MgₐBr₄ (0 < a ≤ 0.7), (C₇H₁₅NH₃)₂Pb₍₁₋ₐ₎CoₐBr₄ (0 < a ≤ 0.7), (C₇H₁₅NH₃)₂Pb₍₁₋ₐ₎MnₐBr₄ (0 < a ≤ 0.7),
(C₄H₉NH₃)₂Pb₍₁₋ₐ₎ZnₐBr_{(4-y)}I_{y} (0 < a ≤ 0.7, 0 < y < 4), (C₄H₉NH₃)₂Pb₍₁₋ₐ₎MgₐBr_{(4-y)}I_{y} (0 < a ≤ 0.7, 0 < y < 4), (C₄H₉NH₃)₂Pb₍₁₋ₐ₎CoₐBr_{(4-y)}I_{y} (0 < a ≤ 0.7, 0 < y < 4), (C₄H₉NH₃)₂Pb₍₁₋ₐ₎MnₐBr_{(4-y)}I_{y} (0 < a ≤ 0.7, 0 < y < 4),
(C₄H₉NH₃)₂Pb₍₁₋ₐ₎ZnₐBr_{(4-y)}Cl_{y} (0 < a ≤ 0.7, 0 < y < 4), (C₄H₉NH₃)₂Pb₍₁₋ₐ₎MgₐBr_{(4-y)}Cl_{y} (0 < a ≤ 0.7, 0 < y < 4), (C₄H₉NH₃)₂Pb₍₁₋ₐ₎CoₐBr_{(4-y)}Cl_{y} (0 < a ≤ 0.7, 0 < y < 4), (C₄H₉NH₃)₂Pb₍₁₋ₐ₎MnₐBr_{(4-y)}Cl_{y} (0 < a ≤ 0.7, 0 < y < 4).

The resin composition may contain only a single kind of semiconductor particle (A) that emits light having a specific wavelength by light radiated from a light source, or may contain a combination of two or more kinds of semiconductor particles (A) that emit lights having different wavelengths. For example, the resin composition may contain only one kind of quantum dots that emit light having a specific wavelength in response to light emitted from a light source, or may contain two or more kinds of quantum dots that emit light having different wavelengths in combination. Examples of the light having a specific wavelength include red light, green light, and blue light.

The content ratio of the semiconductor particle (A) in the resin composition is, for example, 1% by mass or more and 60% by mass or less, preferably 10% by mass or more and 50% by mass or less, more preferably 10% by mass or more and 40° by mass or less, even more preferably 10% by mass or more and 30% by mass or less, still more preferably 10% by mass or more and 20% by mass or less, and particularly preferably 10% by mass or more and 15% by mass or less, based on the total amount of the solid content of the resin composition.

The total amount of the solid content herein means the total of the components, excluding a solvent (G), in the compounds contained in the resin composition. The content in the solid content of the resin composition can be determined by a known analytical technique such as liquid chromatography or gas chromatography. The content ratio of each component in the solid content ratio of the resin composition may also be calculated from the formulation when the resin composition is prepared.

### [2] Organic ligand (F)

The semiconductor particles (A) may be present in the resin composition in a state where the organic ligand is coordinated. Hereinafter, the semiconductor particles to which the organic ligand is coordinated are also referred to as ligand-containing semiconductor particles. The organic ligand to be coordinated to the semiconductor particles is, for example, an organic compound having a polar group exhibiting a coordination ability based on the semiconductor particles. The organic ligand may be an organic ligand added for stabilization or due to synthetic restrictions on the ligand-containing semiconductor particles. For example, in National Publication of Japanese Patent Application No. 2015-529698, the ligand-containing semiconductor particles contain hexanoic acid as an organic ligand from the viewpoint of particle size control, and the organic ligand is replaced by DDSA (dodecenylsuccinic acid) for stabilization after synthesis.

The organic ligand can coordinate to, for example, the surface of the semiconductor particle (A). The resin composition can contain one or more organic ligands (F).

The polar group of the organic ligand is preferably at least one group selected from the group consisting of a thiol group (-SH), a carboxy group (-COOH), and an amino group (-NH₂). The polar group selected from the group can be advantageous in increasing the coordination property to the semiconductor particles (A). The larger coordination property can contribute to the improvement in stability and dispersibility of the semiconductor particle (A) in the resin composition and the improvement in the quantum yield of a resin film. In particular, the polar group is more preferably at least one group selected from the group consisting of a thiol group and a carboxy group. The organic ligand (F) may have one or more polar groups.

The organic ligand may be, for example, an organic compound represented by the following formula (X):

X^{A}-R^{X} (X)

In the formula, X^{A} is the above-mentioned polar group, and R^{X} is a monovalent hydrocarbon group which may contain a heteroatom (N, O, S, halogen atom, or the like). The hydrocarbon group may have one or two or more unsaturated bonds such as carbon-carbon double bonds. The hydrocarbon group may have a linear, branched, or cyclic structure. The number of carbon atoms of the hydrocarbon group is, for example, 1 or more and 40 or less, and may be 1 or more and 30 or less. The methylene group contained in the hydrocarbon group is optionally replaced by -O-, -S-, -C(=O)-, -C(=O)-O-, -O-C(=O)-, - C(=O)-NH-, -NH-, or the like.

The group R^{X} may contain a polar group. With respect to specific examples of the polar group, the above description relating to the polar group X^{A} is referred to.

Specific examples of the organic ligand having a carboxy group as the polar group X^{A} include formic acid, acetic acid, propionic acid, and saturated or unsaturated fatty acids. Specific examples of saturated or unsaturated fatty acids include saturated fatty acids such as butyric acid, pentanoic acid, caproic acid, caprylic acid, capric acid, lauric acid, myristic acid, pentadecylic acid, palmitic acid, margaric acid, stearic acid, arachidic acid, behenic acid, and lignoceric acid; monounsaturated fatty acids such as myristoleic acid, palmitoleic acid, oleic acid, icosenoic acid, erucic acid, and nervonic acid; and polyunsaturated fatty acids such as linoleic acid, α-linolenic acid, γ-linolenic acid, stearic acid, dihomo-γ-linolenic acid, arachidonic acid, eicosatetraenoic acid, docosadienoic acid, and adrenic acid (docosatetraenoic acid).

Specific examples of the organic ligand having a thiol group or an amino group as the polar group X^{A} include organic ligands in which the carboxy group of the organic ligands having a carboxy group as the polar group X^{A} exemplified above is replaced by a thiol group or an amino group.

In addition to the above, examples of the organic ligand represented by the formula (X) include a compound (F-1) and a compound (F-2).

### [Compound (F-1)]

The compound (F-1) is a compound having the first functional group and the second functional group. The first functional group is a carboxy group (-COOH), and the second functional group is a carboxy group or thiol group (-SH). Since the compound (F-1) has a carboxy group and/or a thiol group, it can serve as a ligand coordinating to the semiconductor particle (A). For improving stability and dispersibility of the semiconductor particle (A) and the quantum yield of a resin film, it is advantageous that the compound (F-1) is contained in the resin composition.

The resin composition may contain only one compound (F-1) or may contain two or more compounds (F-1).

An example of the compound (F-1) is a compound represented by the formula (F-1a) below. The compound (F-1) may be an acid anhydride of the compound represented by the formula (F-1a). 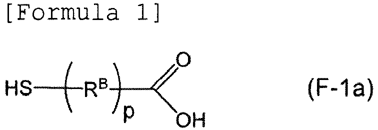 [In the formula, R^{B} represents a divalent hydrocarbon group. A plurality of R^{B}, when present, are optionally the same or different. The hydrocarbon group may have one or more substituents. When there are a plurality of substituents, they may be the same or different, and they may be bonded to each other to form a ring together with the atoms to which they are bonded.-CH₂- contained in the hydrocarbon group is optionally replaced by at least one of -O-, -S-, -SO₂-, -CO-, and - NH-.

p represents an integer of 1 to 10.]

Examples of the divalent hydrocarbon group represented by R^{B} include a chain hydrocarbon group, an alicyclic hydrocarbon group, and an aromatic hydrocarbon group.

Examples of the chain hydrocarbon group include a linear or branched alkanediyl group, and the number of carbon atoms thereof is generally 1 to 50, preferably 1 to 20, and more preferably 1 to 10. Examples of the alicyclic hydrocarbon group include a monocyclic or polycyclic cycloalkanediyl group, and the number of carbon atoms thereof is usually 3 to 50, preferably 3 to 20, and more preferably 3 to 10. Examples of the aromatic hydrocarbon group include a monocyclic or polycyclic arenediyl group, and the number of carbon atoms thereof is generally 6 to 20.

Examples of the substituent that the hydrocarbon group may have include an alkyl group having 1 to 50 carbon atoms, a cycloalkyl group having 3 to 50 carbon atoms, an aryl group having 6 to 20 carbon atoms, a carboxy group, an amino group, and a halogen atom. The substituent that the hydrocarbon group may have is preferably a carboxy group, an amino group, or a halogen atom.

When-CH₂- contained in the hydrocarbon group is replaced by at least one of -O-, -CO-, and -NH-, -CH₂- is preferably replaced by at least one of -CO- and -NH-, and more preferably -NH-. p is preferably 1 or 2.

Examples of the compound represented by the formula (F-1a) include compounds represented by the following formulas (1-1) to (1-9).

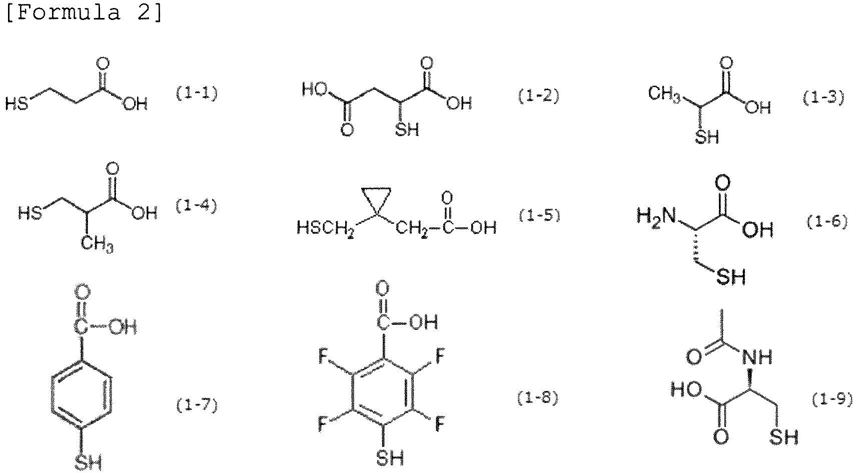

Specific examples of the compound represented by the formula (J-1a) include mercaptoacetic acid, 2-mercaptopropionic acid, 3-mercaptopropionic acid, 3-mercaptobutanoic acid, 4-mercaptobutanoic acid, mercaptosuccinic acid, mercaptostearic acid, mercaptooctanoic acid, 4-mercaptobenzoic acid, 2,3,5,6-tetrafluoro-4-mercaptobenzoic acid, L-cysteine, N-acetyl-L-cysteine, 3-methoxybutyl 3-mercaptopropionate, and 3-mercapto-2-methylpropionic acid. Of these, 3-mercaptopropionic acid and mercaptosuccinic acid are preferable.

Another example of the compound (F-1) is a polycarboxylic acid compound, preferably a compound (F-1b) in which -SH in the formula (F-1a) is replaced by a carboxy group (-COOH) in the compound represented by the formula (F-1a).

Examples of the compound (F-1b) include the following compounds:
Succinic acid, glutaric acid, adipic acid, octafluoroadipic acid, azelaic acid, dodecanedioic acid, tetradecanedioic acid, hexadecanedioic acid, heptadecanedioic acid, octadecanedioic acid, nonadecandioic acid, dodecafluorosuberic acid, 3-ethyl-3-methylglutaric acid, hexafluoroglutaric acid, trans-3-hexenedioic acid, sebacic acid, hexadecafluorosebacic acid, acetylenedicarboxylic acid, trans-aconitic acid, 1,3-adamantandicarboxylic acid, bicyclo[2.2.2]octane-1,4-dicarboxylic acid, cis-4-cyclohexene-1,2-dicarboxylic acid, 1,1-cyclopropanedicarboxylic acid, 1,1-cyclobutanedicarboxylic acid, cis- or trans-1,3-cyclohexanedicarboxylic acid, cis- or trans-1,4-cyclohexanedicarboxylic acid, 1,1-cyclopentanediacetic acid, 1,2,3,4-cyclopentanetetracarboxylic acid, decahydro-1,4-naphthalenedicarboxylic acid, 2,3-norbornanedicarboxylic acid, 5-norbornene-2,3-dicarboxylic acid, phthalic acid, 3-fluorophthalic acid, isophthalic acid, tetrafluoroisophthalic acid, terephthalic acid, tetrafluoroterephthalic acid, 2,5-dimethylterephthalic acid, 2,6-naphthalenedicarboxylic acid, 2,3-naphthalenedicarboxylic acid, 1,4-naphthalenedicarboxylic acid, 1,1'-ferrocenedicarboxylic acid, 2,2'-biphenyldicarboxylic acid, 4,4'-biphenyldicarboxylic acid, 2,5-furandicarboxylic acid, benzophenone-2,4'-dicarboxylic acid monohydrate, benzophenone-4,4'-dicarboxylic acid, 2,3-pyrazinedicarboxylic acid, 2,3-pyridinedicarboxylic acid, 2,4-pyridinedicarboxylic acid, 3,5-pyridinedicarboxylic acid, 2,5-pyridinedicarboxylic acid, 2,6-pyridinedicarboxylic acid, 3,4-pyridinedicarboxylic acid, pyrazole-3,5-dicarboxylic acid monohydrate, 4,4'-stilbenedicarboxylic acid, anthraquinone-2,3-dicarboxylic acid, 4-(carboxymethyl)benzoic acid, chelidonic acid monohydrate, azobenzene-4,4'-dicarboxylic acid, azobenzene-3,3'-dicarboxylic acid, chlorendic acid, 1H-imidazole-4,5-dicarboxylic acid, 2,2-bis(4-carboxyphenyl)hexafluoropropane, 1,10-bis(4-carboxyphenoxy)decane, dipropylmalonic acid, dithiodiglycolic acid, 3,3'-dithiodipropionic acid, 4,4'-dithiodibutanoic acid, 4,4'-dicarboxydiphenyl ether, 4,4'-dicarboxydiphenyl sulfone, ethylene glycol bis(4-carboxyphenyl)ether, 3,4-ethylenedioxythiophene-2,5-dicarboxylic acid, 4,4'-isopropylidenediphenoxyacetic acid, 1,3-acetonedicarboxylic acid, methylenedisalicylic acid, 5,5'-thiodisalicylic acid, tris(2-carboxyethyl)isocyanurate, tetrafluorosuccinic acid, **α**,**α**,**α**',**α**'-tetramethyl-1,3-benzenedipropionic acid, and 1,3,5-benzenetricarboxylic acid.

From the viewpoint of improving stability and dispersibility of the semiconductor particle (A) and the quantum yield of a resin film, the molecular weight of the compound (F-1) is preferably 3000 or less, more preferably 2500 or less, even more preferably 2000 or less, still more preferably 1000 or less, particularly preferably 800 or less, and most preferably 500 or less. The molecular weight of the compound (F-1) is generally 100 or more.

The molecular weight may be a number-average molecular weight or a weight-average molecular weight. In this case, the number-average molecular weight and the weight-average molecular weight are a number-average molecular weight and a weight-average molecular weight in terms of standard polystyrene measured by gel permeation chromatography (GPC), respectively.

In the resin composition, at least a part of the molecules of the compound (F-1) is preferably coordinated to the semiconductor particle (A), and all or almost all the molecules may be coordinated to the semiconductor particle (A). That is, the resin composition preferably contains a compound (F-1) coordinated to the semiconductor particle (A), but may also contain a compound (F-1) not coordinated to the semiconductor particle (A) and a compound (F-1) coordinated to the semiconductor particle (A).

To contain the compound (F-1) coordinating to the semiconductor particle (A) can be advantageous for improving stability and dispersibility of the semiconductor particle (A) and the quantum yield of a resin film. Usually, the compound (F-1) can be coordinated to the semiconductor particle (A) via the first functional group and/or the second functional group. The compound (F-1) can be coordinated to the surface of the quantum dots (A), for example.

In the case where the resin composition contains the compound (F-1), the ratio of the content of the compound (F-1) to that of the semiconductor particle (A) in the resin composition is preferably 0.001 or more and 1 or less, more preferably 0.01 or more and 0.5 or less, and even more preferably 0.02 or more and 0.45 or less, in terms of mass ratio. The ratio between these contents within this range can be advantageous for improving stability and dispersibility of the semiconductor particle (A) and the quantum yield of a resin film.

In the case where the resin composition contains the compound (F-1), the content ratio of the compound (F-1) in the resin composition is preferably 0.1% by mass or more and 20% by mass or less, more preferably 0.2% by mass or more and 20% by mass or less, even more preferably 0.2% by mass or more and 10% by mass or less, still more preferably 0.5% by mass or more and 10% by mass or less, and particularly preferably 0.5% by mass or more and 8% by mass or less, based on the total amount of the solid content of the resin composition, from the viewpoint of improving stability and dispersibility of the semiconductor particle (A) and the quantum yield of a resin film.

### [Compound (F-2)]

The compound (F-2) is a compound (J-2) different from the compound (F-1), and is a compound having a polyalkylene glycol structure and having a polar group at the molecular end. The molecular end is preferably the end of the longest carbon chain in the compound (F-2) (the carbon atom in the carbon chain is optionally replaced by another atom such as an oxygen atom).

The resin composition may contain only one compound (F-2) or two or more thereof. The resin composition may contain the compound (F-1) or the compound (F-2), or may be the compound (F-1) and the compound (F-2).

Compounds having a polyalkylene glycol structure and having the first functional group and the second functional group are considered to belong to the compound (F-1).

The polyalkylene glycol structure refers to a structure represented by the following formula: 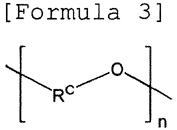 wherein n is an integer of 2 or more. In the formula, R^{C} is an alkylene group, and examples thereof include an ethylene group and a propylene group.

Specific examples of the compound (F-2) include a polyalkylene glycol-based compound represented by the following formula (F-2a).

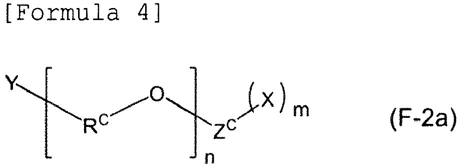

In the formula (F-2a), X is a polar group, Y is a monovalent group, and Z^{C} is a divalent or trivalent group. n is an integer of 2 or more. m is 1 or 2. R^{C} is an alkylene group.

In the resin composition, at least a part of the molecules of the compound (F-2) is preferably coordinated to the semiconductor particle (A), and all or almost all the molecules may be coordinated to the semiconductor particle (A). That is, the resin composition preferably contains a compound (F-2) coordinated to the semiconductor particle (A), but may also contain a compound (F-2) not coordinated to the semiconductor particle (A) and a compound (F-2) coordinated to the semiconductor particle (A).

To contain the compound (F-2) coordinating to the semiconductor particle (A) can be advantageous for improving stability and dispersibility of the semiconductor particle (A) and the quantum yield of a resin film. Usually, the compound (F-2a) can be coordinated to the semiconductor particle (A) via the polar group X. When the group Y contains a polar group, the compound (F-2a) may be coordinated to the semiconductor particle (A) via the polar group of the group Y, or via the polar group X and the polar group of the group Y. The compound (F-2) can be coordinated to the surface of the semiconductor particle (A), for example.

The polar group X is preferably at least one group selected from the group consisting of a thiol group (-SH), a carboxy group (-COOH), and an amino group (-NH₂). The polar group selected from this group can be advantageous for increasing the coordination property to the semiconductor particles. Among others, the polar group X is more preferably as least one group selected from the group consisting of a thiol group and a carboxy group, from the viewpoint of improving stability and dispersibility of the semiconductor particle (A) and the quantum yield of a resin film.

The group Y is a monovalent group. The group Y is not particularly limited, and examples thereof include a monovalent hydrocarbon group which may have a substituent (N, O, S, halogen atom, or the like). -CH₂- contained in the hydrocarbon group is optionally replaced by -O-, -S-, -C(=O)-, -C(=O)-O-, -O-C(=O)-, -C(=O)-NH-, -NH-, or the like.

The number of carbon atoms of the hydrocarbon group is, for example, 1 or more and 12 or less. The hydrocarbon group may have an unsaturated bond.

Examples of the group Y include an alkyl group having a linear, branched, or cyclic structure having 1 or more and 12 or less carbon atoms; and an alkoxy group having a linear, branched, or cyclic structure having 1 or more and 12 or less carbon atoms. The number of carbon atoms of the alkyl group and the alkoxy group is preferably 1 or more and 8 or less, more preferably 1 or more and 6 or less, and still more preferably 1 or more and 4 or less. -CH₂- contained in the alkyl group and the alkoxy group is optionally replaced by -O-, -S-, - C(=O)-, -C(=O)-O-, -O-C(=O)-, -C(=O)-NH-, -NH-, or the like. In particular, the group Y is preferably a linear or branched alkoxy group having 1 or more and 4 or less carbon atoms, and more preferably a linear alkoxy group having 1 or more and 4 or less carbon atoms.

The group Y may contain a polar group. Examples of the polar group include at least one group selected from the group consisting of a thiol group (-SH), a carboxy group (-COOH), and an amino group (-NH₂). However, as described above, compounds having a polyalkylene glycol structure and having the first functional group and the second functional group are considered to belong to the compound (F-1). The polar group is preferably located at the end of the group Y.

The group Z^{C} is a divalent or trivalent group. The group Z^{C} is not particularly limited, and examples thereof include a divalent or trivalent hydrocarbon group which may contain a heteroatom (N, O, S, halogen atom, or the like). The number of carbon atoms of the hydrocarbon group is, for example, 1 or more and 24 or less. The hydrocarbon group may have an unsaturated bond.

Examples of the group Z^{C} which is a divalent group include an alkylene group having a linear, branched, or cyclic structure having 1 or more and 24 or less carbon atoms; and an alkenylene group having a linear, branched, or cyclic structure having 1 or more and 24 or less carbon atoms. The number of carbon atoms of the alkyl group and the alkenylene group is preferably 1 or more and 12 or less, more preferably 1 or more and 8 or less, and still more preferably 1 or more and 4 or less. -CH₂-contained in the alkyl group and the alkenylene group is optionally replaced by -O-, -S-, -C(=O)-, -C(=O)-O-, -O-C(=O)-, -C(=O)-NH-, -NH-, or the like. Examples of the group Z^{C} which is a trivalent group include a group obtained by removing one hydrogen atom from the group Z^{C} which is a divalent group described above.

The group Z^{C} may have a branched structure. The group Z^{C} having a branched structure may have a polyalkylene glycol structure different from the polyalkylene glycol structure represented by the formula (F-2a) in a branched chain different from the branched chain including the polyalkylene glycol structure represented by the formula (F-2a).

In particular, the group Z^{C} is preferably a linear or branched alkylene group having 1 or more and 6 or less carbon atoms, and more preferably a linear alkylene group having 1 or more and 4 or less carbon atoms.

R^{C} is an alkylene group, and is preferably a linear or branched alkylene group having 1 or more and 6 or less carbon atoms, and more preferably a linear alkylene group having 1 or more and 4 or less carbon atoms.

n in the formula (F-2a) is an integer of 2 or more, preferably 2 or more and 540 or less, more preferably 2 or more and 120 or less, and still more preferably 2 or more and 60 or less.

The molecular weight of the compound (F-2) can be, for example, about 150 or more and about 10000 or less, and is preferably 150 or more and 5000 or less, and more preferably 150 or more and 4000 or less, from the viewpoint of improving stability and dispersibility of the semiconductor particle (A) and the quantum yield of a resin film.

The molecular weight may be a number-average molecular weight or a weight-average molecular weight. In this case, the number-average molecular weight and the weight-average molecular weight are a number-average molecular weight and a weight-average molecular weight in terms of standard polystyrene measured by GPC, respectively.

In the case where the resin composition contains the compound (F-2), the ratio of the content of the compound (F-2) to that of the semiconductor particle (A) in the resin composition is preferably 0.001 or more and 2 or less, more preferably 0.01 or more and 1.5 or less, and even more preferably 0.1 or more and 1 or less, in terms of mass ratio. The ratio between these contents within this range can be advantageous for improving stability and dispersibility of the semiconductor particle (A) and the quantum yield of a resin film.

In the case where the resin composition contains the compound (F-2), the content ratio of the compound (F-2) in the resin composition is preferably 0.1 % by mass or more and 40 % by mass or less, more preferably 0.1 % by mass or more and 20 % by mass or less, even more preferably 1 % by mass or more and 15 % by mass or less, and still more preferably 2 % by mass or more and 10 % by mass or less, based on the total amount of the solid content of the resin composition, from the viewpoint of improving stability and dispersibility of the semiconductor particle (A) and the quantum yield of a resin film.

In the case where the resin composition contains the compound (F-1) and the compound (F-2), the ratio of the content of the compound (F-2) to that the compound (F-1) in the resin composition is preferably 1 or more and 50 or less, more preferably 5 or more and 40 or less, and even more preferably 10 or more and 25 or less, in terms of mass ratio. The ratio between these contents within this range can be advantageous for improving stability and dispersibility of the semiconductor particle (A) and the quantum yield of a resin film.

The resin composition can further contain a compound (F-3), which is a compound different from the compound (F-1) or the compound (F-2) and is capable of coordinating to the semiconductor particle (A). Examples of the compound (F-3) include an organic acid, an organic amine compound, and a thiol compound. The compound (F-3) may be, for example, a silicone oil modified with a carboxy group and an amino group or a thiol group. The compound (F-3) can be contained in the resin composition to thereby regulate the characteristics (e.g., surface characteristics including the contact angle and the surface tension) of a resin film. The compound (F-3) does not encompass the resin (B), the polymerizable compound (c), the polymerization initiator (D), the polymerization initiation aid (D1), the light scattering agent (E), the solvent (G), the antioxidant (H), or the leveling agent (I).

In the case where the resin composition contains the compound (F-3), the ratio of the content of the compound (F-3) to that of the semiconductor particle (A) in the resin composition is preferably 0.001 or more and 2 or less, more preferably 0.01 or more and 1.5 or less, and even more preferably 0.1 or more and 1 or less, in terms of mass ratio. The ratio between these contents within this range can be advantageous for improving stability and dispersibility of the semiconductor particle (A) and the quantum yield of a resin film.

In the case where the resin composition contains the compound (F-3), the content ratio of the compound (F-3) in the resin composition is preferably 0.1 % by mass or more and 40 % by mass or less, more preferably 0.1 % by mass or more and 20 % by mass or less, even more preferably 0.2 % by mass or more and 15 % by mass or less, and still more preferably 0.2 % by mass or more and 10 % by mass or less, based on the total amount of the solid content of the resin composition, from the viewpoint of improving stability and dispersibility of the semiconductor particle (A) and the quantum yield of a resin film.

In the case where the resin composition contains the organic ligand (F), the ratio of the content of the organic ligand (F) to that of the semiconductor particle (A) in the resin composition is preferably 0.001 or more and 1 or less, more preferably 0.01 or more and 0.8 or less, and even more preferably 0.02 or more and 0.5 or less, in terms of mass ratio. The ratio between these contents within this range can be advantageous for improving stability and dispersibility of the semiconductor particle (A) and the quantum yield of a resin film. The content of the organic ligand (F) here means the total content of all the organic ligand(s) contained in the resin composition.

From the viewpoint of improving stability and dispersibility of the semiconductor particle (A) and the quantum yield of a resin film, the total content ratio of the semiconductor particle (A) and the organic ligand (F) in the resin composition is preferably 10 % by mass or more and 75 % by mass or less, more preferably 12 % by mass or more and 65 % by mass or less, and even more preferably 15 % by mass or more and 55 % by mass or less, based on the total amount of the solid content of the resin composition.

### [3] Resin (B)

The resin (B) may contain one or more resins. Examples of the resin (B) include the following resins [K1] to [K4]:
resin [K1]: copolymer of at least one (a) (hereinafter also referred to as "(a)") selected from the group consisting of an unsaturated carboxylic acid and an unsaturated carboxylic acid anhydride and a monomer (c) (hereinafter also referred to as "(c)") copolymerizable with (a) (but different from (a));
resin [K2]: resin obtained by reacting a copolymer of (a) and (c) with a monomer (b) (hereinafter also referred to as "(b)") having a cyclic ether structure having 2 to 4 carbon atoms and an ethylenically unsaturated bond;
resin [K3]: resin obtained by reacting a copolymer of (b) and (c) with (a); and
resin [K4]: resin obtained by reacting a copolymer of (b) and (c) with (a) and further reacting with a carboxylic acid anhydride.

Examples of (a) include unsaturated monocarboxylic acids such as (meth)acrylic acid, crotonic acid, and o-, m-, and p-vinylbenzoic acid;
unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
bicyclo unsaturated compounds containing a carboxy group, such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic acid anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride;
unsaturated mono[(meth)acryloyloxyalkyl]esters of di- or higher polycarboxylic acids such as mono[2-(meth)acryloyloxyethyl]succinate and mono[2-(meth)acryloyoxyethyl]phthalate; and
unsaturated (meth)acrylates containing a hydroxy group and a carboxy group in the same molecule, such as **α**-(hydroxymethyl) (meth)acrylic acid.

Of these, (meth) acrylic acid, maleic anhydride and the like are preferable from the viewpoint of copolymerization reactivity, for example.

As used herein, the term (meth)acrylic acid means acrylic acid and/or methacrylic acid. The same applies to "(meth)acryloyl", "(meth)acrylate" and the like.

(b) is, for example, a monomer having a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether structure having 2 to 4 carbon atoms and a (meth)acryloyloxy group.

Examples of (b) include monomers having an oxirane ring and an ethylenically unsaturated bond, such as glycidyl (meth)acrylate, β-methylglycidyl (meth)acrylate, β-ethylglycidyl (meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl) styrene, 2,6-bis(glycidyloxymethyl)styrene, 2,3,4-tris(glycidyloxymethyl) styrene, 2,3,5-tris(glycidyloxymethyl)styrene, 2,3,6-tris(glycidyloxymethyl) styrene, 3,4,5-tris(glycidyloxymethyl)styrene, and 2,4,6-tris(glycidyloxymethyl) styrene;
monomers having an oxetane ring and an ethylenically unsaturated bond, such as 3-methyl-3-methacryloyloxymethyloxetane, 3-methyl-3-acryloyloxymethyloxetane, 3-ethyl-3-methacryloyloxymethyloxetane, 3-ethyl-3-acryloyloxymethyloxetane, 3-methyl-3-methacryloyloxyethyloxetane, 3-methyl-3-acryloyloxyethyloxetane, 3-ethyl-3-methacryloyloxyethyloxetane, and 3-ethyl-3-acryloyloxyethyloxetane; and
monomers having a tetrahydrofuran ring and an ethylenically unsaturated bond, such as tetrahydrofurfuryl acrylate (for example, Viscoat V#150, manufactured by OSAKA ORGANIC CHEMICAL INDUSTRY LTD.) and tetrahydrofurfuryl methacrylate.
(b) is preferably a monomer having an oxirane ring and an ethylenically unsaturated bond, because the reactivity during the production of the resins [K2] to [K4] is high and unreacted (b) hardly remains.

Examples of (c) include (meth)acrylic esters such as methyl (meth)acrylate, ethyl (meth)acrylate, n-butyl (meth)acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, tricyclo[5.2.1.0^{2,6}]decan-8-yl (meth)acrylate (referred to as "dicyclopentanyl (meth)acrylate" (common name) in the art or sometimes referred to as "tricyclodecyl (meth)acrylate"), tricyclo[5.2.1.0^{2,6}]decen-8-yl (meth)acrylate (which is referred to as "dicyclopentenyl (meth)acrylate" (common name) in the art), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, and benzyl (meth)acrylate;
hydroxy group-containing (meth)acrylic esters such as 2-hydroxyethyl (meth)acrylate and 2-hydroxypropyl (meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide; and
styrene, **α**-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance of the resin (C), styrene, vinyltoluene, N-phenylmaleimide, N-cyclohexylmaleimide, N-benzylmaleimide, bicyclo[2.2.1]hept-2-ene and the like are preferable.

In the resin [K1], the ratio of the structural unit derived from each of (a) and (c) in the total structural units constituting the resin [K1] is preferably the following:
the structural unit derived from (a): 2 mol% or more and 60 mol% or less; and
the structural unit derived from (c): 40 mol% or more and 98 mol% or less,
and more preferably the following:
the structural unit derived from (a): 10 mol% or more and 50 mol% or less; and
the structural unit derived from (c): 50 mol% or more and 90 mol% or less.

When the ratio of the structural units of the resin [K1] is within the above range, the resin composition tends to be excellent in storage stability and solvent resistance of the obtained resin film.

In the case where the resin (B) contains the structural unit derived from (a), the resin (B) can contain two or more structural units derived from (a), and in that case, the ratio (the content ratio in terms of mole) of the structural unit derived from (a) is the total sum of the ratios of the structural units. The same also applies to a structural unit derived from another monomer such as (b) and (c).

The resin [K1] can be produced with reference to the method disclosed in for example, a document "Experimental Method for Polymer Synthesis" (edited by Takayuki Otsu, published by Kagaku-Dojin Publishing Company, INC, First Edition, First Printed on Mar. 1, 1972) and cited documents described in the above-mentioned document.

Specific examples thereof include the following method: predetermined amounts of (a) and (c), a polymerization initiator, a solvent and the like are placed in a reaction vessel; for example, a deoxidization atmosphere is formed by replacing oxygen with nitrogen; and these are heated or kept warm during stirring.

The polymerization initiator, the solvent and the like which are used are not particularly limited, and those commonly used in the art can be used. Examples of the polymerization initiator include azo compounds (2,2'-azobisisobutyronitrile, 2,2'-azobis(2,4-dimethylvaleronitrile) and the like) and organic peroxides (benzoyl peroxide and the like), and the solvent may be a solvent capable of dissolving each monomer, and examples of the solvent (G) that may be contained in the resin composition include solvents to be described later.

A solution after a reaction, of the resultant copolymer may be used as it is; a concentrated or diluted solution of the copolymer may be used; or a solid (powder) taken out from the copolymer by a method such as reprecipitation may be used. When the solvent (G) described later is used as the solvent for the polymerization, the solution after the reaction can be used as it is for the preparation of the resin composition, whereby the producing process of the resin composition can be simplified.

The resin [K2] can be produced by adding a cyclic ether having 2 to 4 carbon atoms of (b) to the copolymer of (a) and (c), that is, to a carboxylic acid and/or a carboxylic acid anhydride of (a).

The copolymer of (a) and (c) is first produced in the same manner as in the method described as the method for producing the resin [K1]. In this case, the ratio of the structural unit derived from each of (a) and (c) is preferably the same ratio as that described in the resin [K1] .

Next, a cyclic ether having 2 to 4 carbon atoms of (b) is reacted with a part of the carboxylic acid and/or the carboxylic acid anhydride derived from (a) in the copolymer.

Subsequent to the production of the copolymer of (a) and (c), the resin [K2] can be produced by replacing a nitrogen atmosphere in a flask with air, and reacting (b) in the presence of a reaction catalyst for a carboxylic acid or a carboxylic acid anhydride and a cyclic ether (for example, an organic phosphorus compound, a metallic complex, or an amine compound), and a polymerization inhibitor (for example, hydroquinone and the like), for example, at 60°C or more and 130°C or less for 1 to 10 hours.

The amount of (b) used is preferably 5 mol or more and 80 mol or less, and more preferably 10 mol or more and 75 mol or less, based on 100 mol of (a). Within this range, the storage stability of the resin composition and the solvent resistance, heat resistance and mechanical strength of the resin film tend to be well balanced.

Examples of the organic phosphorus compound as a reaction catalyst include triphenylphosphine. As the amine compound as the reaction catalyst, for example, an aliphatic tertiary amine compound or an aliphatic quaternary ammonium salt compound can be used, and specific examples thereof include tris(dimethylaminomethyl)phenol, triethylamine, tetrabutylammonium bromide, and tetrabutylammonium chloride. From the viewpoint of quantum yield of the resin film, the reaction catalyst is preferably an organic phosphorus compound.

The amount of the reaction catalyst used is preferably 0.001 part by mass or more and 5 parts by mass or less based on 100 parts by mass of the total amount of (a), (b), and (c).

The amount of the polymerization inhibitor used is preferably 0.001 part by mass or more and 5 parts by mass or less based on 100 parts by mass of the total amount of (a), (b), and (c) .

The reaction conditions such as the charging method, the reaction temperature and the time can be appropriately adjusted in consideration of the production equipment, the amount of heat generated by the polymerization, and the like. In the same manner as the polymerization conditions, the charging method and the reaction temperature can be appropriately adjusted in consideration of the production equipment, the amount of heat generated by the polymerization, and the like.

The resin [K3] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural unit derived from each of (b) and (c) based on the total number of moles of the total structural units constituting the copolymer is preferably the following:
the structural unit derived from (b): 5 mol% or more and 95 mol% or less; and
the structural unit derived from (c): 5 mol% or more and 95 mol% or less,
and more preferably the following:
the structural unit derived from (b): 10 mol% or more and 90 mol% or less; and
the structural unit derived from (c): 10 mol% or more and 90 mol% or less.

The resin [K3] can be produced by reacting a carboxylic acid or a carboxylic acid anhydride of (a) with the cyclic ether derived from (b) contained in the copolymer of (b) and (c) under the same conditions as those of the method for producing the resin [K2].

The amount of (a) used which is reacted with the copolymer is preferably 5 mol or more and 80 mol or less based on 100 mol of (b).

The resin [K4] is a resin obtained by further reacting the resin [K3] with a carboxylic acid anhydride. A carboxylic acid anhydride is reacted with a hydroxy group generated by a reaction between a cyclic ether and a carboxylic acid or a carboxylic anhydride.

Examples of the carboxylic acid anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, 5,6-dicarboxybicyclo[2.2.1]hept-2-ene anhydride.

The amount of the carboxylic acid anhydride used is preferably 0.5 to 1 mol based on 1 mol of the amount used in (a).

Specific examples of the resin (K1), the resin (K2), the resin (K3), and the resin (K4) include a resin [K1] such as a benzyl (meth)acrylate/(meth)acrylic acid copolymer and a styrene/(meth)acrylic acid copolymer;
a resin [K2] such as a resin produced by adding glycidyl (meth)acrylate to a benzyl (meth)acrylate/(meth)acrylic acid copolymer, a resin produced by adding glycidyl (meth)acrylate to a tricyclodecyl (meth)acrylate/styrene/(meth)acrylic acid copolymer, or a resin produced by adding glycidyl (meth)acrylate to a tricyclodecyl (meth)acrylate/benzyl (meth)acrylate/(meth)ac rylic acid copolymer; a resin [K3] such as a resin produced by reacting a tricyclodecyl (meth)acrylate/glycidyl (meth)acrylate copolymer with (meth)acrylic acid or a resin produced by reacting a tricyclodecyl (meth)acrylate/styrene/glycidyl (meth)acrylate copolymer with (meth)acrylic acid; and a resin [K4] such as a resin produced by reacting a tricyclodecyl (meth)acrylate/glycidyl (meth)acrylate copolymer with (meth)acrylic acid to produce a resin and then reacting this resin with tetrahydrophthalic anhydride.

In particular, the resin (B) preferably contains at least one selected from the group consisting of the resin [K2], the resin [K3], and the resin [K4].

As a further example of the resin (B), the resin disclosed in Japanese Patent Laid-Open No. 2018-123274 can be mentioned. Examples of the resin include a polymer (hereinafter, also referred to as "resin (Ba)") which has a double bond in a side chain, includes a structural unit (**α**) represented by the following formula (I) and a structural unit (**β**) represented by the following formula (II) in a main chain, and further includes an acid group.

The acid group may be introduced into the resin when, for example, the resin (Ba) contains a structural unit (**γ**) derived from an acid group-containing monomer (for example, (meth)acrylic acid). The resin (Ba) preferably contains the structural units (**α**), (**β**), and (**γ**) in the main chain skeleton. 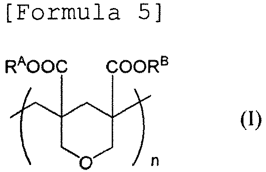 [In the formula, R^{A} and R^{B} are the same or different and each represent a hydrogen atom or a hydrocarbon group having 1 to 25 carbon atoms. n represents the average number of repeating units of the structural units represented by the formula (I), and is a number of 1 or more.] 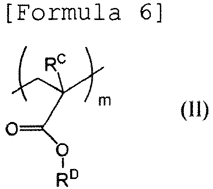 [In the formula, each R^{C} is the same or different and represents a hydrogen atom or a methyl group. Each R^{D} is the same or different and represents a linear or branched chain hydrocarbon group having 4 to 20 carbon atoms. m represents the average number of repeating units of the structural units represented by the formula (II), and is a number of 1 or more.]

The content proportion of the structural unit (**α**) in the resin (Ba) is, for example, from the viewpoint of heat resistance and storage stability of the resin (Ba), 0.5% by mass or more and 50% by mass or less, preferably 1% by mass or more and 40% by mass or less, and more preferably 5% by mass or more and 30% by mass or less based on 100% by mass of the total amount of all monomer units that give the main chain skeleton of the resin (Ba). In the formula (I), n represents the average number of repeating units of the structural units (**α**) in the resin (Ba), and n can be set so that the content proportion of the structural units (**α**) falls within the above range.

The content proportion of the structural unit (**β**) is, for example, from the viewpoint of the solvent resistance of the resin film, 10% by mass or more and 90% by mass or less, preferably 20% by mass or more and 80% by mass or less, and more preferably 30% by mass or more and 75% by mass or less based on 100% by mass of the total amount of all monomer units that give the main chain skeleton of the resin (Ba). In the formula (II), m represents the average number of repeating units of the structural units (**β**) in the resin (Ba), and m can be set so that the content proportion of the structural units (**β**) falls within the above range.

The content proportion of the structural unit (**γ**) is, for example, from the viewpoint of the solubility of the resin (Ba) in the solvent (G), 0.5% by mass or more and 50% by mass or less, preferably 2% by mass or more and 50% by mass or less, and more preferably 5% by mass or more and 45% by mass or less based on 100% by mass of the total amount of all monomer units that give the main chain skeleton of the resin (Ba).

The resin (B) can include one or more selected from the group consisting of the resin [K1], resin [K2], resin [K3], resin [K4], and resin (Ba) described above.

The resin (B) preferably has a ratio of the weight-average molecular weight Mw to the acid value [unit: mg KOH/g], Mw/acid value, of 150 or less, more preferably 120 or less, even more preferably 100 or less, still more preferably 90 or less, particularly preferably 85 or less, and most preferably 70 or less. The Mw/acid value within this range can be advantageous for improving the quantum yield of a resin film. This is probably because the dispersibility of the semiconductor particle (A) in the resin composition is improved. It is considered that the quantum yield of a resin film tends to be higher as the dispersibility is higher. The Mw/acid value is generally 20 or more, and may be 30 or more, or 40 or more.

The Mw of the resin (B) can be controlled by appropriately combining the reaction conditions including the selection of starting materials used, the method for charging them, and the reaction temperature and time. The acid value of the resin (B) can be controlled by the content ratio(s) of the monomer component(s) having an acid group (e.g., the above described (a)).

The Mw of the resin (B) is the weight-average molecular weight, in terms of standard polystyrene, as measured by GPC. Specifically, the Mw can be measured according to the measurement method described in the section of Examples, which will be described later. Alternatively, the Mw may be measured by GPC for the resin (B) contained in the resin composition. The acid value of the resin (B) is a value found as the amount (mg) of potassium hydroxide necessary for neutralizing 1 g of the resin (B), and can be obtained by titrating with, for example, an aqueous potassium hydroxide solution. Specifically, the acid value can be measured according to the measurement method described in the section of Examples, which will be described later. Alternatively, for the resin (B) contained in the resin composition, structural analysis thereof may be performed to determine the acid value, for example.

The Mw of the resin (B) is generally more than 2900. The Mw of the resin (B) is preferably 3000 or more and 12000 or less, more preferably 3000 or more and 10000 or less, even more preferably 3000 or more and 9000 or less, and still more preferably 3500 or more and 8500 or less, from the viewpoint of allowing the Mw/acid value to fall within the above range, and furthermore, improving the quantum yield of a resin film.

The molecular weight distribution [weight-average molecular weight (Mw) / number-average molecular weight (Mn)] of the resin (B) measured by GPC is, for example, 1.0 or more and 6.0 or less, and preferably 1.2 or more and 4.0 or less, from the viewpoint of improving the quantum yield of a resin film.

The acid value of the resin (B) is preferably 90 mg KOH/g or more and 150 mg KOH/g or less, more preferably 90 mg KOH/g or more and 140 mg KOH/g or less, even more preferably 90 mg KOH/g or more and 130 mg KOH/g or less, still more preferably 90 mg KOH/g or more and 120 mg KOH/g or less, and particularly preferably 95 mg KOH/g or more and 110 mg KOH/g or less, from the viewpoint of allowing the Mw/acid value to fall within the above range, and furthermore, improving the quantum yield of a resin film. The resin (B) having an acid value within the above-described range is advantageous also for improving the solvent resistance of a resin film.

From the viewpoint of improving the quantum yield of a resin film, the resin (B) preferably contains a resin having a double bond equivalent of 300 g/eq or more and 2000 g/eq or less, and more preferably 500 or more and 1500 g/eq or less. Examples of the resin having a double bond equivalent of 300 g/eq or more and 2000 g/eq or less include (meth)acrylic resins. The resin (B) is preferably composed of a (meth)acrylic resin.

The content ratio of the resin (B) in the resin composition is, for example, 5 % by mass or more and 85 % by mass or less, preferably 10 % by mass or more and 85 % by mass or less, and more preferably 20 % by mass or more and 85 % by mass or less, and may be 30 % by mass or more and 80 % by mass or less, based on the total amount of the solid content of the resin composition. When the content ratio of the resin (B) is within the above range, the semiconductor particle (A) tends to be easily dispersed and the quantum yield of a resin film thus tends to be improved.

The ratio of the content of the semiconductor particle (A) to the content of the resin (B) is 0.90 or less in terms of mass ratio. When the ratio is within this range, a resin film having good quantum yield can be formed. The reasons for this is probably as follows: when the ratio is within this range, the dispersibility of the semiconductor particle (A) in the resin (B) is higher, and that concentration quenching of the emission by the semiconductor particle (A) is thus suppressed. There is a tendency that the quantum yield of the resin film is higher as the ratio is smaller. From the viewpoint of improving the quantum yield of a resin film, the ratio is preferably 0.88 or less, more preferably 0.85 or less, even more preferably 0.80 or less, still more preferably 0.70 or less, and particularly preferably 0.60 or more, and is also preferably 0.50 or less, 0.40 or less, 0.30 or less, or 0.20 or less.

If the ratio of the content of the semiconductor particle (A) to the content of the resin (B) is too small, the content of the semiconductor particle (A) in the resin composition and also a resin film formed therefrom is relatively so small that the emission intensity of the resin film may be too small. Accordingly, the ratio is preferably 0.01 or more, more preferably 0.02 or more, and even more preferably 0.05 or more.

The ratio of the total content of the semiconductor particle (A) and the organic ligand (F) to the content of the resin (B) is preferably 1.00 or less in terms of mass ratio. When the ratio is within this range, a resin film having good quantum yield can be formed more easily. The reason for this is probably as follows: when the ratio is within this range, the dispersibility of the semiconductor particle (A), or the semiconductor particle (A) coordinated with the organic ligand (F), in the resin (B) is higher, and concentration quenching of the emission by the semiconductor particle (A) is thus suppressed. There is a tendency that the quantum yield of the resin film is higher as the ratio is smaller. From the viewpoint of improving the quantum yield of a resin film, the ratio is more preferably 0.98 or less, even more preferably 0.95 or less, still more preferably 0.90 or less, and particularly preferably 0.80 or more, and is also preferably 0.70 or less, 0.60 or less, 0.50 or less, 0.40 or less, or 0.20 or less.

If the ratio of the total content of the semiconductor particle (A) and the organic ligand (F) to the content of the resin (B) is too small, the content of the semiconductor particle (A) in the resin composition and also the resin film formed therefrom is relatively so small that the emission intensity of the resin film may be too small. Accordingly, the ratio is preferably 0.06 or more, more preferably 0.10 or more, and more preferably 0.15 or more.

For further improving the quantum yield of a resin film, it is preferable to add the resin (B) in portions to the dispersion of the semiconductor particle (A) in the preparation of the resin composition, as described later.

### [4] Polymerizable compound (C) and polymerization initiator (D)

The resin composition according to the present invention contains substantially no polymerizable compound (C) or polymerization initiator (D). Herein, "contains substantially no ..." means that the content ratio of that component is 0.01 % by mass or less based on the total amount of the solid content of the resin composition. The content ratio of the polymerizable compound (C) and the content ratio of the polymerization initiator (D) are each preferably 0.005 % by mass or less, and more preferably 0 % by mass.

The resin composition according to the present invention that contains substantially no polymerizable compound (C) or polymerization initiator (D) is advantageous for forming a resin film having a good quantum yield. Conventionally, a resin film containing a semiconductor particle such as quantum dots has been prepared by applying a curable composition containing the semiconductor particle, a resin, a polymerizable compound, and a polymerization initiator, curing the composition by light or heat, and then optionally developing the resultant. However, the present inventor has found that the semiconductor particle may be deteriorated by an active radical or an acid generated from the polymerization initiator by light or heat, and that the quantum yield of the resin film may be thus decreased. The resin composition according to the present invention, which contains substantially no polymerization initiator, does not bring about the deterioration factor as described above. Accordingly, the deterioration of the semiconductor particle can be prevented or suppressed, and as a result, a resin film having a good quantum yield is easily formed.

The resin composition according to the present invention contains substantially no polymerization initiator (D), and in addition, contains substantially no polymerizable compound (C). The reason for this is as follows in terms of the quantum yield: when a resin composition contains substantially no polymerization initiator (D) but substantially contains the polymerizable compound (C), a resin film to be formed from the resin composition contains an unreacted polymerizable compound (C), which may be a factor of a decreased quantum yield of the resin film. In addition, the polymerizable compound (C) may disadvantageously migrate to a layer adjacent to the resin film in a display device including the resin film.

The polymerizable compound (C) refers to a compound that can be polymerized by an active radical, an acid, or the others generated from the polymerization initiator (D) and has a weight-average molecular weight of 2900 or less. Examples of the polymerizable compound (C) having a weight-average molecular weight of 2900 or less include a photopolymerizable compound such as a compound having an ethylenically unsaturated bond, including a (meth)acrylate ester compound. The weight-average molecular weight of the polymerizable compound (C) is a weight-average molecular weight, in terms of standard polystyrene measured by GPC. The weight-average molecular weight of the polymerizable compound (C) is generally 150 or more.

The compound having an ethylenically unsaturated bond is, for example, a polymerizable compound having three or more ethylenically unsaturated bonds. Examples of such a polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Other examples of the polymerizable compound (C) include a thermally polymerizable compound. It is also preferable that the resin composition according to the present invention should contain substantially no thermally polymerizable compound. The meaning of "contain substantially no ..." is as described above, and the content ratio of the thermally polymerizable compound is more preferably 0.005 % by mass or less, and even preferably 0 % by mass, based on the total amount of the solid content of the resin composition. The thermally polymerizable compound may be any of known thermally polymerizable compounds. The thermally polymerizable compound herein means that having a weight-average molecular weight of 2900 or less.

The polymerization initiator (D) is a compound that initiates polymerization of the polymerizable compound (C). The polymerization initiator (D) is, for example, a compound that generates an active radical, an acid, or the others by the action of light or heat. Examples of the polymerization initiator (D) include a photopolymerization initiator such as an oxime compound, a biimidazole compound, a triazine compound, and an acylphosphine compound, and a thermal polymerization initiators such as an azo compound and an organic peroxide.

Examples of the oxime compound include an oxime compound, having a partial structure represented by the following formula (d). * represents a bond.

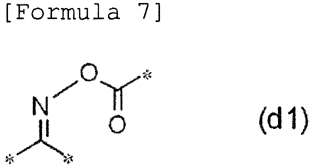

Examples of the oxime compound having a partial structure represented by the formula (d1) include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, and N-benzoyloxy-1-[9-ethyl-6-(2-methylbenzoyl)-9H-carbazole-3-yl]-3-cyclopentylpropan-1-one-2-imine, and compounds disclosed in Japanese Patent Laid-Open No. 2011-132215, International Publication No. 2008/78678, International Publication No. 2008/78686, and International Publication No. 2012/132558.

Examples of the biimidazole compound include a compound represented by the formula (d5): 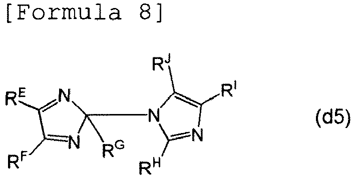 [In the formula (d5), R^{E} to R^{J} represent an aryl group having 6 to 10 carbon atoms which may have a substituent.]

Examples of the aryl groups having 6 to 10 carbon atoms include a phenyl group, a tolyl group, a xylyl group, an ethylphenyl group, and a naphthyl group. Examples of the substituent include a halogen atom and an alkoxy group having 1 to 4 carbon atoms. Examples of the alkoxy group having 1 to 4 carbon atoms include a methoxy group, an ethoxy group, a propoxy group, and a butoxy group.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 06-75372 and Japanese Patent Laid-Open No. 06-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and an imidazole compound in which phenyl groups at the 4,4',5,5' positions are each substituted with a carboalkoxy group (for example, see Japanese Patent Laid-Open No. 7-10913). More specific examples include compounds represented by the following formulas and a mixture thereof.

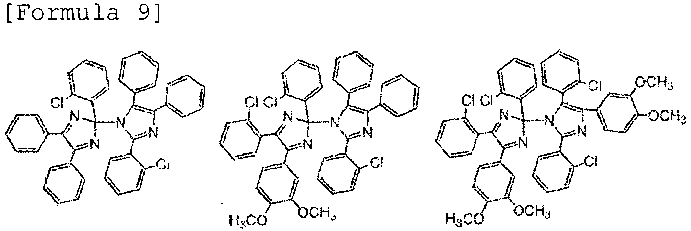

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine compound include bis(2,4,6-trimethylbenzoyl)phenylphosphine oxide and (2,4,6-trimethylbenzoyl)diphenylphosphine oxide.

Examples of the photopolymerization initiator other than the above include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4¹-methyldiphenyl sulfide, 3,3',4,4'-tetra(tert-butylperoxycarbonyl)benzophenone, 2,4,6-trimethylbenzophenone, and 4,4'-bis(diethylamino)benzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound.

Other examples of the polymerization initiator (D) include a thermal polymerization initiator. It is also preferable that the resin composition according to the present invention should contain substantially no thermal polymerization initiator. The meaning of "contain substantially no ..." is as described above, and the content ratio of the thermal polymerization initiator is more preferably 0.005 % by mass or less, and even preferably 0 % by mass, based on the total amount of the solid content of the resin composition. The thermal polymerization initiator may be any of known thermal polymerization initiators.

It is preferable that the resin composition should contain substantially no polymerization initiation aid (D1), from the viewpoint of improving the quantum yield of a resin film. The polymerization initiation aid (D1) is a compound used for accelerating the polymerization of the polymerizable compound (C) initiated by the polymerization initiator (D), or a sensitizer. Examples of the polymerization initiation aid (D1) include a photopolymerization initiation aid such as an amine compound, an alkoxyanthracene compound, a thioxanthone compound, and a carboxylic acid compound, and a thermal polymerization initiation aid.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone.

Examples of the alkoxy anthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

### [5] Light scattering agent (E)

The resin composition may contain a light scattering agent (E). A resin film formed from such a resin composition optionally has the light scattering property. The resin composition may contain two or more light scattering agents (E).

Examples of the light scattering agent (E) include inorganic particles such as particles of metal or metal oxide, and glass particles. Examples of the metal oxide include TiO₂, SiO₂, BaTiO₃, and ZnO, and particles of TiO₂, which efficiently scatter light, are preferable. The particle size of the light scattering agent (E) is, for example, about 0.03 µm or more and about 20 µm or less, preferably 0.05 µm or more and 1 µm or less, and more preferably 0.05 µm or more and 0.5 µm or less.

The light scattering agent (E) may be previously dispersed in a part or the whole of the solvent (G) with a dispersant, before use. The dispersant used may be a commercially available product. Examples of the commercially available products include:
DISPERBYK-101, 102, 103, 106, 107, 108, 109, 110, 111, 116, 118, 130, 140, 154, 161, 162, 163, 164, 165, 166, 170, 171, 174, 180, 181, 182, 183, 184, 185, 190, 192, 2000, 2001, 2020, 2025, 2050, 2070, 2095, 2150, 2155; ANTI-TERRA-U, U100, 203, 204, 250, ; BYK-P104, P104S, P105, 220S, 6919; BYK-LPN6919, and 21116; LACTIMON and LACTIMON-WS; Bykumen; and the like, manufactured by BYK Japan KK;
SOLSPERSE-3000, 9000, 13000, 13240, 13650, 13940, 16000, 17000, 18000, 20000, 21000, 24000, 26000, 27000, 28000, 31845, 32000, 32500, 32550, 33500, 32600, 34750, 35100, 36600, 38500, 41000, 41090, 53095, 55000, 76500, and the like, manufactured by Lubrizol Japan Limited;
EFKA-46, 47, 48, 452, 4008, 4009, 4010, 4015, 4020, 4047, 4050, 4055, 4060, 4080, 4400, 4401, 4402, 4403, 4406, 4408, 4300, 4310, 4320, 4330, 4340, 450, 451, 453, 4540, 4550, 4560, 4800, 5010, 5065, 5066, 5070, 7500, 7554, 1101, 120, 150, 1501, 1502, 1503, and the like, manufactured by BASF Japan Ltd.; and
AJISPER PA111, PB711, PB821, PB822, and PB824, manufactured by Ajinomoto Fine-Techno Co., Inc.

The content ratio of the light scattering agent (E) in the curable resin composition is, for example, 0.001% by mass or more and 50% by mass or less based on the total amount of the solid content of the resin composition, and from the viewpoint of improving the light scattering property and the quantum yield of a resin film, preferably 1% by mass or more and 30% by mass or less, and more preferably 2% by mass or more and 20% by mass or less.

### [6] Solvent (G)

The resin composition can contain a solvent (G). The solvent (G) is not particularly limited as long as it dissolves the resin (B), and any solvent generally used in the art can be used. Examples thereof include an ester solvent (a solvent that contains -COO- but does not contain -O- in its molecule), an ether solvent (a solvent that contains -O- but does not contain -COO- in its molecule), an ether ester solvent (a solvent that contains -COO- and-O- in its molecule), a ketone solvent (a solvent that contains -CO- but does not contain -COO- in its molecule), an alcohol solvent (a solvent that contains OH but does not contain -O-, -CO- nor -COO- in its molecule), an aromatic hydrocarbon solvent, an amide solvent, and dimethyl sulfoxide. Two or more solvents may be used in combination for the solvent (G).

Examples of the ester solvent include methyl lactate, ethyl lactate, n-butyllactate, methyl 2-hydroxy isobutanoate, ethyl acetate, n-butylacetate, isobutylacetate, n-pentyl formate, isopentyl acetate, n-butylpropionate, isopropyl butyrate, ethyl butyrate, n-butylbutyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-butyl methoxyacetate, 3-methyl-3-butyl methoxyacetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin. Examples of the aromatic hydrocarbon solvent include benzene, toluene, xylene, and mesitylene. Examples of the amide solvent include N,N-dimethylformamide, N,N-dimethylacetamide, and N-methylpyrrolidone.

The solvent (G) is preferably propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone, or toluene, or a mixture of two or more thereof.

The solvent (G) is a component other than the solid content, and for example, the solvent contained in the semiconductor particle (A), the resin (B), or the others is also encompassed by the solvent (G). The content ratio of the solvent (G) in the resin composition is the ratio of the total mass of all the solvents contained in the composition, based on the total amount of the composition, and is, for example, 40% by mass or more and 95% by mass or less, preferably 55% by mass or more and 90% by mass or less, based on the total amount of the resin composition. In other words, the solid content of the resin composition is preferably 5% by mass or more and 60% by mass or less, and more preferably 10% by mass or more and 45% by mass or less. When the content ratio of the solvent (G) is within the above range, there is a tendency that the flatness of the composition layer at the time of coating is better, and also that a resin film having an appropriate film thickness is easily formed.

### [7] Antioxidant (H)

The resin composition may contain an antioxidant (H). The antioxidant (H) is not particularly limited as long as it is an antioxidant that is generally used industrially, and a phenol-based antioxidant, a phosphorus-based antioxidant, a phosphorus/phenol composite antioxidant, a sulfur-based antioxidant, and the like can be used. Two or more kinds of the antioxidants (H) may be used in combination.

The phosphorus/phenol composite antioxidant may be a compound having one or more phosphorus atoms and one or more phenol structures in its molecule. From the viewpoint of the quantum yield of the resin film, the antioxidant (H) preferably contains a phosphorus/phenol composite antioxidant.

Examples of the phenol-based antioxidant include Irganox (R) 1010 (Irganox 1010: pentaerythritol tetrakis[3-(3,5-di-tert-butyl-4-hydroxyphenyl)propionate], manufactured by BASF Japan Ltd.), Irganox 1076 (Irganox 1076: Octadecyl-3-(3,5-di-tert-butyl-4-hydroxyphenyl)propionate, manufactured by BASF Japan Ltd.), Irganox 1330 (Irganox 1330: 3,3',3",5,5',5"-hexa-tert-butyl-a,a',a''-(mesitylene-2,4,6-triyl)tri-p-cresol, BASF Japan Ltd.), Irganox 3114 (Irganox 3114: 1,3,5-tris(3,5-di-tert-butyl-4-hydroxybenzyl)-1,3,5-triazine-2,4,6(1H,3H,5H)-trione, BASF Japan Ltd.), Irganox 3790 (Irganox 3790: 1,3,5-tris((4-tert-butyl-3-hydroxy-2,6-xylyl)methyl)-1,3,5-triazine-2,4,6(1H,3H,5H)-trione, BASF Japan Ltd.), Irganox 1035 (Irganox 1035: thiodiethylenebis[3-(3,5-di-tert-butyl-4 hydroxyphenyl)propionate], manufactured by BASF Japan Ltd.), Irganox 1135 (Irganox 1135: 3,5-bis(1,1-dimethylethyl)-4-hydroxy-C7-C9 side-chain alkyl ester of benzene propanoic acid, manufactured by BASF Japan Ltd.), Irganox 1520 L (Irganox 1520 L: 4,6-bis(octylthiomethyl)-o-cresol, manufactured by BASF Japan Ltd.), Irganox 3125 (Irganox 3125, BASF Japan Ltd.), Irganox 565 (Irganox 565: 2,4-bis(n-octylthio)-6-(4-hydroxy-3',5'-di-tert-butylanilino)-1,3,5-triazine, manufactured by BASF Japan Ltd.), ADK STAB (R) AO-80 (ADK STAB AO-80: 3,9-bis(2-(3-(3-tert-butyl-4-hydroxy-5-methylphenyl)propionyloxy)-1,1-dimethylethyl)-2,4,8,10-tetraoxaspiro(5,5)undecane, manufactured by ADEKA Corporation), SUMILIZER (R) BHT, SUMILIZER GA-80, SUMILIZER GS (manufactured by Sumitomo Chemical Co., Ltd.), Cyanox (R) 1790 (Cyanox 1790, manufactured by Cytec Industries Inc.), and vitamin E (manufactured by Eisai Co., Ltd.).

Examples of the phosphorus-based antioxidant include Irgafos (R) 168 (Irgafos 168: tris(2,4-di-tert-butylphenyl)phosphite, manufactured by BASF Japan Ltd.), Irgafo12 (Irgafos 12: tris[2-[[2,4,8,10-tetra-tert-butyldibenzo[d,f][1,3,2]-dioxaphosphine-6-yl]oxy]ethyl]amine, manufactured by BASF Japan Ltd.), Irgafos 38 (Irgafos 38: bis(2,4-bis(1,1-dimethylethyl)-6-methylphenyl)ethyl ester phosphite, BASF Japan Ltd.), ADK STAB (R) 329K, Irgafos PEP36, Irgafos PEP-8 (all manufactured by ADEKA Corporation), Sandstab P-EPQ (manufactured by Clariant AG), Weston (R) 618, Weston 619G (manufactured by GE), and Ultranox 626 (manufactured by GE).

Examples of the phosphorus/phenol composite antioxidant include SUMILIZER (R) GP (6-[3-(3-tert-butyl-4-hydroxy-5-methylphenyl)propoxy]-2,4,8,10-tetra-tert-butyldibenz[d,f][1.3.2]dioxaphosphepine) (manufactured by Sumitomo Chemical Co., Ltd.).

Examples of the sulfur-based antioxidant include dialkyl thiodipropionate compounds such as dilauryl thiodipropionate, dimyristyl thiodipropionate, and distearate thiodipropionate; and β-alkylmercaptopropionic acid ester compounds of polyols such as tetrakis[methylene(3-dodecylthio)propionate]methane.

In the case where the resin composition contains the antioxidant (H), the content of the antioxidant (H) in the curable resin composition is, for example, 0.01 part by mass or more and 10.0 parts by mass or less based on 100 parts by mass of the resin (B), and is preferably 0.1 parts by mass or more and 8.0 parts by mass or less, more preferably 1.0 parts by mass or more and 7.0 parts by mass or less, and still more preferably 2.0 parts by mass or more and 6.0 parts by mass or less, from the viewpoint of, for example, the amount of the light emission and heat resistance of a resin film.

In the case where the resin composition contains the antioxidant (H), the content of the antioxidant (H) in the resin composition is, for example, 0.01 part by mass or more and 0.5 parts by mass or less based on 100 parts by mass of the total amount of the semiconductor particle (A) and the organic ligand (F) in the resin composition, and is preferably 0.02 parts by mass or more and 0.4 parts by mass or less, more preferably 0.03 parts by mass or more and 0.3 parts by mass or less, and still more preferably 0.03 parts by mass or more and 0.2 parts by mass or less, from the viewpoint of, for example, the amount of the light emission and heat resistance of a resin film.

### [8] Other components and viscosity of resin composition

If necessary, the resin composition may further contain additives known in the art, such as a polymerization inhibitor, a filler, another polymeric compound, an adhesion promoter, a light stabilizer, a chain transfer agent, and a leveling agent.

The viscosity of the resin composition at 25°C is, for example, 50 mPa·s or more and 30000 mPa·s or less, and is preferably 80 mPa·s or more and 30000 mPa·s or less, more preferably 100 mPa·s or more and 25000 mPa·s or less, and even more preferably 200 mPa·s or more and 20000 mPa·s or less, from the viewpoint of coatability of the resin composition and good appearance of a resin film formed by coating. The viscosity of the resin composition can be measured using a Brookfield rotational viscometer.

### <Method for producing resin composition>

The resin composition can be produced according to a method including the step of mixing the specific components and other components used as necessary. The method for producing the resin composition may further include the step of preparing the resin (B).

The method for producing the resin composition preferably includes:
the step of preparing or providing a dispersion of the semiconductor particle (A) (dispersion-preparing step); and
the step of adding the resin (B) to the dispersion (resin-adding step).

The dispersion-preparing step may be the step of preparing a dispersion of the semiconductor particle (A) or the step of providing a commercially available product of a dispersion of the semiconductor particle (A). The step of preparing a dispersion of the semiconductor particle (A) may include the substep of adding an organic ligand to the dispersion of the semiconductor particle (A) (the dispersion may contain another organic ligand). The step of preparing a dispersion of the semiconductor particle (A) may include the substep of replacing the whole or a part of the organic ligand contained in the dispersion of the semiconductor particle (A) with another organic ligand; or the substep of replacing the whole or a part of the solvent contained in the dispersion with another solvent. In the case where the resin composition contains the organic ligand (F), the organic ligand (F) is preferably contained in the dispersion of the semiconductor particle (A) prepared or provided in the dispersion-preparing step. The solvent contained in the dispersion obtained from the dispersion-preparing step is preferably at least one solvent of the solvent (G) to be contained in the resin composition.

The resin-adding step is, for example, the step of adding a solution containing the resin (B) to the dispersion of the semiconductor particle (A). The solvent contained in the dispersion and the solvent contained in the solution containing the resin (B) may be the same or may be different. The solvent contained in the solution containing the resin (B) is preferably at least one solvent of the solvent (G) to be contained in the resin composition.

From the viewpoint of improving the quantum yield of a resin film, the solution containing the resin (B) is preferably added in portions to the dispersion of the semiconductor particle (A). Especially, when the solution containing the resin (B) is added in portions in an amount such that the ratio of the total content of the semiconductor particle (A) and the organic ligand (F) to the content of the resin (B) is 1.00 or less in mass ratio, the quantum yield of a resin film formed from the resin composition obtained can be more effectively improved. The reason for this is probably as follows: when the resin (B) is added in portions, the semiconductor particle (A), or the semiconductor particle (A) coordinated with the organic ligand, is gradually dispersed into the resin (B), resulting higher dispersibility, and concentration quenching of the emission by the semiconductor particle (A) is thus suppressed more. The quantum yield-improving effect brought about by adding in portions is especially effectively exhibited when the concentration of the semiconductor particle (A) or the semiconductor particle (A) coordinated with the organic ligand (F) relative to the resin (B) is as small as the above ratio is 1.00 or less.

Adding the solution containing the resin (B) in portions means dividing the solution into a plurality of portions and adding these portions of the solution at intervals. The solution is divided into at least two portions, and preferably into three or more portions. Each portion of the solution may be added all collectively, or may be added continuously over a certain time (for example, 60 seconds or more and 120 minutes or less). The rate of addition when adding continuously is, for example, 1.0 g/h or more and 250 g/h or less, preferably 1.0 g/h or more and 100 g/h or less, and more preferably 1.5 g/h or more and 50 g/h or less.

The plurality of portions of solution may be in the same amounts or different amounts. The time of the interval is, for example, 30 seconds or more and 30 minutes or less, and preferably 30 seconds or more and 10 minutes or less. When the solution containing the resin (B) is added to the dispersion of the semiconductor particle (A), the temperatures of the dispersion and the solution are, for example, 10°C or more and 100°C or less, and preferably 25°C or more and 80°C or less. It is preferable that the solution containing the resin (B) should be added to the dispersion of the semiconductor particle (A) while the dispersion is stirred. The stirring rate is, for example, 50 rpm or more and 500 rpm or less, and preferably 100 rpm or more and 300 rpm or less.

The components to be contained in the resin composition, excluding the semiconductor particle (A), the organic ligand (F), and the resin (B), may be added to the dispersion of the semiconductor particle (A) before the resin-adding step, or may be contained in the solution containing the resin (B) used in the resin-adding step, or may be added after the resin-adding step. As described above, a solvent contained in the dispersion of the semiconductor particle (A) and a solvent contained in the solution containing the resin (B) can be at least a part of the solvent (G) to be contained in the resin composition. After the resin-adding step, a solvent may be added as a part of the solvent (G) to be contained in the resin composition.

### <Resin film and method for producing it>

The resin film according to the present invention is a film formed from the resin composition according to the present invention as described above. The resin film can be obtained, for example, according to a method including the step of applying the resin composition to a substrate and the step of then drying the resultant. The resin film may be formed on the entire surface of the substrate or may be formed in a pattern on a part of the substrate. Examples of the method for forming a resin film in a pattern include an inkjet method and a printing method. Examples of the printing method include a stencil printing method, a screen printing method, and printing by coating with an applicator.

Examples of the substrate include a glass plate made from, for example, quartz glass, borosilicate glass, alumina silicate glass, soda lime glass of which the surface is coated with silica, or the like; a resin plate made from, for example, polycarbonate, polymethyl methacrylate, polyethylene terephthalate or the like; a substrate made from silicon; and a substrate produced by forming a thin film made from aluminum, silver or a silver/copper/palladium alloy or the like on a substrate.

The patterned resin film can be prepared in the following manner, for example. First, the resin composition is applied to a substrate via a mask to form a patterned composition layer. Examples of the method for applying the resin composition include a spin coating method, a slit coating method, and a slit and spin coating method.

Next, the composition layer is dried (volatile components including the solvent are removed) to thereby obtain a resin film. Examples of the drying method include heat-drying, drying under reduced pressure, and a combination thereof. The temperature to be employed in the case where heat-drying is carried out is preferably 30°C or more and 250°C or less, and more preferably 50°C or more and 235°C. The heating time is preferably 10 seconds or more and 180 minutes or less, and more preferably 30 seconds or more and 90 minutes or less. In the case where drying under reduced pressure is carried out, it is preferred to carry out under a pressure of 50 Pa or more and 150 Pa or less. The step of drying the composition layer may be carried out through a plurality of substeps, and for example, a plurality of drying substeps at different drying temperatures may be carried out.

The film thickness of the resin film is not particularly limited, and may be selected appropriately depending on the objects. The film thickness is, for example, 1 µm or more and 30 µm or less, preferably 3 µm or more and 25 µm or less, more preferably 5 µm or more and 25 µm or less, and still more preferably 5 µm or more and 20 µm or less. The shape and the size of the patterned resin film is not particularly limited. The patterned resin film is, for example, square-shaped in its plan view.

By irradiating the resin film with ultraviolet light or visible light, the resin film can emit light having a wavelength different from that of the irradiation light. The wavelength of light to be emitted can be selected by selecting the component and the particle size of the semiconductor particle (A). Since the resin film functions to convert the wavelength of irradiation light, it can be used as, for example, a color conversion layer of a display device.

The resin film can exhibit good quantum yield. The resin film preferably has a quantum yield of 65% or more, more preferably 70% or more, still more preferably 75% or more, and yet still more preferably 80% or more, as measured in accordance with the measurement method described later in the section of Examples.

### <Display device>

The resin film according to the present invention is useful as a color conversion layer (wavelength conversion layer) of a display device, in particular, a liquid crystal display device, an organic EL display device, or an inorganic EL display device, as it can have good quantum yield. Examples of such a display device include display devices disclosed in Japanese Patent Laid-Open No. 2006-309219, Japanese Patent Laid-Open No. 2006-310303, Japanese Patent Laid-Open No. 2013-15812, Japanese Patent Laid-Open No. 2009-251129, and Japanese Patent Laid-Open No. 2014-2363.

The display device according to the present invention includes the resin film described above, and generally, further includes a light source. The display device is not particularly limited, and may further include layers such as a light absorption layer, a light reflection member (such as a reflection film), a diffusion film, a brightness enhancement unit, a prism sheet, a light guide plate, and a medium material layer between elements.

The light absorption layer is a layer having wavelength selectivity that transmits light in a specific wavelength range and absorbs light in other wavelength ranges. The light absorption layer is usually a layer containing a colorant such as a dye or a pigment, and can be arranged on the resin film. As the light absorption layer, a conventionally known color filter can be used.

The light reflection member is a member for reflecting the light of the light source toward the resin film, and may be a reflecting mirror, a film of reflective particles, a reflective metal film, a reflective body, or the like. The diffusion film is a film for diffusing the light of a light source or the light emitted from a resin film, and may be an amplified diffusing film or the like. The brightness enhancement unit is a member for reflecting a part of light back in the direction in which the light is transmitted.

The prism sheet typically has a base material section and a prism section. The base material section may be omitted, depending on the adjacent members. The prism sheet can be pasted together with the adjacent members via any appropriate adhesive layer (for example, an adhesive layer or a pressure sensitive adhesive layer). The prism sheet is configured to have a plurality of unit prisms that are convex in parallel on the side opposite to the visible side (rear side). By arranging the convex sections of the prism sheet toward the rear side, the light that passes through the prism sheet is more likely to be focused. Also, when the convex sections of the prism sheet are arranged toward the rear side, there is less light reflected without incident on the prism sheet compared to the case where the convex sections are arranged toward the visible side, and a display device with high brightness can be obtained.

Any appropriate light guide plate may be used as the light guide plate. For example, a light guide plate having a lens pattern formed on the rear side such that light from the lateral direction can be deflected in the thickness direction or a light guide plate having a prism shape or the like formed on the rear side and/or the visible side can be used.

The display device may include a layer composed of one or more medium materials on the optical path between adjacent elements (layers). Examples of the one or more medium materials include, but not limited to, vacuum, air, gas, optical materials, adhesives, optical adhesives, glass, polymers, solids, liquids, gels, cured materials, optical bonding materials, refractive index matching or refractive index mismatching materials, refractive index gradient materials, cladding or anti-cladding materials, spacers, silica gel, brightness enhancement materials, scattering or diffusion materials, reflective or anti-reflective materials, wavelength selective materials, wavelength selective anti-reflective materials, or other suitable media known in the art.

Specific examples of the display device include those provided with a wavelength conversion material for an EL display or a liquid crystal display. Specific examples thereof include a display device in which the resin film as a wavelength conversion layer is disposed between a blue light source and a light guide plate along an end surface (side surface) of the light guide plate to form a backlight (on-edge type backlight) that emits white light, and a light absorption layer is arranged on the light guide plate side; a display device in which the resin film as a wavelength conversion layer is disposed on a light guide plate to form a backlight (surface mounting type backlight) that emits light emitted from a blue light source disposed on an end surface (side surface) of the light guide plate to the wavelength conversion layer through the light guide plate as white light, and a light absorption layer is disposed on the wavelength conversion layer; and a display device in which the resin film is disposed in the vicinity of a light-emitting portion of a blue light source to form a wavelength conversion layer, a backlight (on-chip backlight) that emits irradiated light as white light, and a light absorption layer is disposed on the wavelength conversion layer.

### Examples

Hereinafter, the present invention will be described in more detail by way of examples. Unless otherwise specified, "%" and "part" in the example are % by mass and parts by mass.

### <Measurement-Evaluation>

### (1) Quantum yield QY of resin film

The quantum yield (%) of the resin film was measured using an absolute PL quantum yield spectrometer "C9920-02G" manufactured by Hamamatsu Photonics K.K. The sample used for measurement was a glass substrate with a resin film formed thereon having a film thickness of 10 µm. The resin film was formed by applying the resin composition to the glass substrate with a film applicator ("AP75" manufactured Taiyu Kizai Co., Ltd.), dried on a hot plate at 100°C for 3 minutes, and then drying 180°C for 10 minutes.

### (2) Weight-average molecular weight Mw of resin

The weight-average molecular weight Mw of the resin was measured by the GPC method under the following conditions.
Equipment: K2479 (manufactured by Shimadzu Corporation)
Column: SHIMADZU Shim-pack GPC-80M
Column temperature: 40°C
Solvent: tetrahydrofuran
Flow rate: 1.0 mL/min
Detector: RI
Standard for calibration; TSK STANDARD POLYSTYRENE F-40, F-4, F-288, A-2500, A-500 (manufactured by Tosoh Corporation)

### (3) Acid value of resin

3 g of the resin solution was finely weighed, dissolved in a mixed solvent of 90 g of acetone and 10 g of water, and the acid value of the resin solution was measured using an automatic titrator (manufactured by HIRANUMA Co., Ltd., trade name: COM-555) with a 0.1N aqueous KOH solution as the titrant, and the acid value per 1 g of the solid (mg KOH/g) was determined from the acid value of the solution and the solid content of the solution.

### (4) Solid content of resin solution

About 1 g of the resin solution was weighed in an aluminum cup, dried at 180°C for 1 hour, and then the mass was measured. The solid content (% by mass) of the resin solution was calculated from the mass reduction.

### (5) Viscosity of resin composition (25°C)

The viscosity was measured using a Brookfield rotational viscometer under the conditions of a constant temperature of 25°C and a rotating speed of 3 rpm.

### <Production Example 1: Preparation of dispersion of semiconductor particles (A-1)>

A toluene dispersion of InP/ZnSeS quantum dots coordinated with oleic acid as an organic ligand (F) was prepared. The dispersion was distilled under reduced pressure to remove toluene. To 30 parts of the solid content, 70 parts of cyclohexyl acetate was added to obtain a dispersion (solid content: 30%) of semiconductor particles (A-1).

### <Production Example 2: Preparation of dispersion of light scattering agent (E-1)>

DISPERBYK21116 (manufactured by BYK Japan KK) was added to 70 parts of titanium oxide nanoparticles in a solid content of 3 parts and propylene glycol monomethyl ether acetate (hereinafter referred to as "PGMEA") in a total amount of 100 parts, and the mixture was stirred with a paint shaker until it was sufficiently dispersed to obtain a dispersion (solid content: 73%) of a light scattering agent (E-1).

### <Production Example 3: Preparation of resin (B-1) solution>

After 110 parts of PGMEA was put into a flask equipped with a stirrer, a reflux cooling tube with a thermometer, a dropping funnel, and a nitrogen introduction tube, the mixture was stirred while purging nitrogen, and the temperature was raised to 80°C. A solution obtained by dissolving 25 parts of dicyclopentanyl methacrylate, 26 parts of methyl methacrylate, 16 parts of methacrylic acid, and 14 parts of 2,2'-azobis(2,4-dimethylvaleronitrile) in 110 parts of PGMEA was dropped from a dropping funnel into a flask, and stirred at 80°C for 3 hours.

Next, 16 parts of glycidyl methacrylate, 0.4 parts of 2,2'-methylenebis(4-methyl-6 tert-butylphenol), and 0.8 parts of triphenylphosphine were put into a flask, and the temperature was raised to 110°C and stirred for 8 hours to react the carboxylic acid in the polymer with the epoxy group to introduce a polymerizable unsaturated bond. Then, 17 parts of 1,2,3,6-tetrahydrophthalic acid anhydride was added and the reaction was continued for 3 hours to introduce carboxylic acid groups into the side chains. The reaction solution was cooled to room temperature to obtain a resin (B-1) solution.

The resin (B-1) had a weight-average molecular weight Mw of 5200 in terms of standard polystyrene, a molecular weight distribution of 2.3, and an acid value of 100 mg KOH/g, and the solid content in the resin (B-1) solution was 40% by mass.

### <Production Example 4: Preparation of resin (B-2) solution>

A resin (B-2) solution was obtained in the same manner as in Production Example 3, except that the amounts of methyl methacrylate, methacrylic acid, and 2,2'-azobis(2,4-dimethylvaleronitrile) were changed to 23 parts by mass, 19 parts by mass, 10 parts by mass, respectively.

The resin (B-2) had a weight-average molecular weight Mw of 8400 in terms of standard polystyrene, a molecular weight distribution of 2.2, and an acid value of 100 mg KOH/g, and the solid content in the resin (B-2) solution was 40% by mass.

### <Examples 1 to 5, Comparative Examples 1, 2>

A resin composition was prepared in the following manner.

First, the dispersion of the semiconductor particle (A-1), which was obtained in Production Example 1 and contained the organic ligand (F), was heated to 80°C. To the semiconductor particle dispersion under heating, the resin (B-1) solution (25°C) obtained in Production Example 3 was added in portions, followed by mixing. In the addition in portions, the solution was divided into three portions, and the interval between the additions of the portions was 10 minutes. Each portion of the solution was all added collectively. Then, the dispersion of the light scattering agent (E-1) obtained in Production Example 2, an antioxidant (H-1), and a solvent (G-1) as a part of the solvent (G) were added thereto, and the resultant was mixed to obtain a resin composition.

The content of each component in the resin composition obtained from the addition amount is as shown in Table 1. In Table 1, the contents of components other than the solvent (G) are in terms of solid content (unit: parts by mass). The unit of the content of the solvent (G) is parts by mass. For example, the semiconductor particles (A-1) are blended as a dispersion of the semiconductor particles (A-1) in the preparation of the resin composition, and the content shown in Table 1 is the amount of the semiconductor particles (A-1) itself contained in the dispersion. The solvent (G) in Table 1 contains a solvent contained in the dispersion or solution used for preparing the resin composition.

The content of the organic ligand (F) in the resin composition shown in Table 1 was calculated, on the basis of the measurement of the concentration of the organic ligand (F) in the dispersion of the semiconductor particle (A-1) obtained in Production Example 1 according to the following method. Specifically, the solvent was removed by vacuum-drying the dispersion of the semiconductor particle (A-1) at 150°C, and then, the weight change of the remaining solid was measured at a temperature increasing rate of 5°C/min from 50°C to 550°C using a thermogravimetric analyzer "TGDTA 6200". The weight change from 50°C to 500°C was regarded as the weight of the organic ligand (F), and from this, the concentration of the organic ligand (F) in the dispersion of the semiconductor particle (A-1) was calculated.

### <Example 4>

A resin composition was obtained in the same manner as in Example 1, except that the dispersion of light scattering agent (H-1) obtained in Production Example 2 was not added, and that the contents of the components in the resin composition were as shown in Table 1.

### <Example 5>

A resin composition was obtained in the same manner as in Example 1, except that the resin (B-2) solution obtained in Production Example 4 was used instead of the resin (B-1) solution obtained in Production Example 3, and that the contents of the components in the resin composition were as shown in Table 1.

### <Comparative Example 2>

A resin composition was obtained in the same manner as in Example 1, except that the contents of the components in the resin composition were as shown in Table 1.

For the resin compositions obtained, the quantum yield QY of each resin film formed therefrom was measured and evaluated according to the above. The results are shown in Table 1. Table 1 also shows the mass ratio of the content of the semiconductor particle (A) to the content of the resin (B) in the resin composition ((A)/(B) in Table 1), the mass ratio of the total content of the semiconductor particle (A) and the organic ligand (F) to the content of the resin (B) in the resin composition ([(A)+(F)]/(B) in Table 1), and the viscosity of the resin composition at 25°C.

**[Table 1]**

| | | Example | | | | | Comparative example | |
|---|---|---|---|---|---|---|---|---|
| | | 1 | 2 | 3 | 4 | 5 | 1 | 2 |
| Semiconductor particle (A) | A-1 | 18.5 | 10.9 | 32.6 | 18.5 | 18.5 | 43.4 | 38.2 |
| Organic ligand (F) | | 7. 2 | 4. 2 | 12.5 | 7.2 | 7.2 | 16.7 | 14.8 |
| Resin (B) | B-1 | 66.7 | 77.3 | 97.3 | 71.7 | | 33.2 | 39.7 |
| | B-2 | | | | | 66.7 | | |
| Light scattering agent (E) | E-1 | 5.0 | 5.0 | 5.0 | | 5.0 | 5.0 | 5.0 |
| Antioxidant (H) | H-1 | 2.6 | 2.6 | 2.6 | 2.6 | 2.6 | 1.7 | 2.3 |
| Total | | 100 | 100 | 100 | 100 | 100 | 100 | 100 |
| Solvent (G) | G-1 | 66 | 66 | 66 | 66 | 66 | 66 | 66 |
| | G-2 | 56 | 56 | 56 | 56 | 56 | 56 | 56 |
| Resin (B) | Mw | 5200 | 5200 | 5200 | 5200 | 8100 | 5200 | 5200 |
| | Acid value | 100 | 100 | 100 | 100 | 100 | 100 | 100 |
| | Mw/ Acid value | 52 | 52 | 52 | 52 | 84 | 52 | 52 |
| (A)/(B) | | 0.28 | 0.14 | 0.69 | 0.26 | 0.28 | 1.31 | 0.96 |
| [(A)+(F)]/(B) | | 0.39 | 0.20 | 0.95 | 0.36 | 0.39 | 1.81 | 1.34 |
| Viscosity of resin composition | (mPa · s) | 110 | 125 | 105 | 140 | 118 | 102 | 104 |
| Quantum yield (%) | | 80 | 84 | 77 | 71 | 69 | 63 | 64 |

The details of the abbreviations of the components shown in Table 1 are as follows.
[1] Organic ligand (F): oleic acid
[2] Solvent (G-1): PGMEA (propylene glycol monomethyl ether acetate)
[3] Solvent (G-2): cyclohexyl acetate
[4] Antioxidant (H-1): Sumilizer-GP (phosphorus/phenol composite antioxidant, manufactured by Sumitomo Chemical Co., Ltd., solid content: 100%)

## Claims

1. A resin composition comprising a semiconductor particle (A) and a resin (B),
wherein a content of a polymerizable compound (C) and a content of a polymerization initiator (D) are each 0.01 % by mass or less based on a total amount of a solid content of the resin composition, and
a ratio of a content of the semiconductor particle (A) to that of the resin (B) is 0.90 or less in terms of mass ratio.

2. The resin composition according to claim 1, wherein the resin composition further comprises an organic ligand (F) or no organic ligand (F), and
a ratio of a total content of the semiconductor particle (A) and the organic ligand (F) to the content of the resin (B) is 1.00 or less in terms of mass ratio.

3. The resin composition according to claim 1, wherein the content of the polymerizable compound (C) and the content of the polymerization initiator (D) are each 0 % by mass based on the total amount of the solid content of the resin composition.

4. The resin composition according to claim 1, wherein a ratio of the weight-average molecular weight of the resin (B) to an acid value of the resin (B) is 150 or less.

5. The resin composition according to claim 1, further comprising a light scattering agent (E).

6. The resin composition according to claim 1, having a viscosity of 100 mPa·s or more and 30000 mPa·s or less at 25°C.

7. A resin film formed from the resin composition according to any one of claims 1 to 6.

8. A display device comprising the resin film according to claim 7.
